# EUROPEAN PATENT APPLICATION

(11) **EP 4 480 970 A1**
(43) Date of publication of application: **25.12.2024**
(21) Application number: 23756118.8
(22) Date of filing: 25.01.2023
(51) Int. Cl.: C08F 8/00, C08C 19/20, C08G 59/02, C08G 59/40, C08J 5/24, H01L 23/29, H01L 23/31

(54) **POLYHYDRIC PHENOLIC RESIN, AS WELL AS RESIN COMPOSITION, CURED PRODUCT THEREOF, AND USE THEREOF**

(30) Priority: 17.02.2022 JP 2022022955
(71) Applicant: AJINOMOTO CO., INC., Chuo-ku Tokyo 104-8315 (JP)
(72) Inventor: OGURA, Ichiro, Kawasaki-shi, Kanagawa 210-0801 (JP); SATO, Naoya, Kawasaki-shi, Kanagawa 210-0801 (JP)
(74) Representative: Mewburn Ellis LLP
(86) International application number: PCT/JP2023/002255
(87) International publication number: WO 2023/157590

(57) **Abstract**

Provided is a novel polyhydric phenol resin which achieves a cured product exhibiting a favorable toughnesses. The polyhydric phenol resin (X) contains a polydiene skeleton and the polyhydric phenol resin (X) is characterized by containing a structural unit represented by the following formula (1): 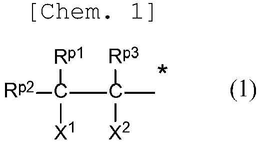 (In the formula (1), R^{p1} and R^{p3} each independently represent a hydrogen atom, a methyl group, or an ethyl group, R^{p2} represents a hydrogen atom, a methyl group, or a bond, one of X¹ and X² represents a hydroxy group, the other represents a monovalent group represented by the formula (2) below, and * represents a bond. Here, the C-C bond structure in the formula (1) is a part of the polydiene skeleton. 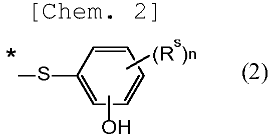 In the formula (2), R^{S} each independently represents a substituent, * represents a bond, and n represents a number of 0 to 4.)

## Description

### TECHNICAL FIELD

The present invention relates to a polyhydric phenol resin. In addition, the present invention relates to a production method of the polyhydric phenol resin, a resin composition including the polyhydric phenol resin, a cured product thereof, and uses thereof such as a resin sheet, a prepreg, a printed wiring board, a semiconductor chip package and a semiconductor device.

### BACKGROUND ART

Because of superior properties such as a mechanical strength and a heat resistance, a phenol resin is widely used in automotive components such as a brake, as well as electronic components such as a semiconductor chip package and a printed wiring board.

For example, a blend of a phenol resin with a curing agent such as hexamine or methylol melamine, or with an epoxy resin as a curing agent, may be thermally cured to obtain a rigid cured product. A phenol resin is also used as a raw material for an epoxy resin. Furthermore, a blend of a phenol resin with a photosensitive agent such as a photoacid generator and a naphthoquinone diazide compound is also used as a photoresist for a semiconductor and for a liquid crystal display.

A common phenol resin is a phenol formaldehyde resin such as a phenol novolac resin, which is a polycondensation product of phenols with formaldehyde. By controlling a molecular weight and changing a type of the phenol, for example, to a cresol or an alkylphenol, properties such a moldability, a heat resistance, and a mechanical property of the phenol resin may be improved. However, a cured product of the phenol resin has inherent drawbacks that it is inflexible, hard, and brittle. A remedial measure for these drawbacks is to add a rubber component or other material that imparts flexibility, but this measure often causes a detrimental effect of reducing a mechanical strength.

As the remedial measure from the viewpoint of a molecular structure, an alicyclic skeleton nodular phenol resin obtained by a polyaddition reaction of dicyclopentadiene with phenol is proposed in Patent Literature 1, an aralkyl phenol resin having xylylene as a nodular group is proposed in Patent Literature 2, and a biphenyl aralkyl resin having a biphenyl skeleton as a nodular group is proposed in Patent Literature 3.

### RELATED ART REFERENCE

### Patent Literature

Patent Literature 1: Japanese Patent Application Laid-open No. H03-179021
Patent Literature 2: Japanese Patent Application Laid-open No. S63-238151
Patent Literature 3: Japanese Patent Application Laid-open No. 2001-040053

### SUMMARY OF INVENTION

### PROBLEM TO BE SOLVED BY THE INVENTION

In the modified phenol resins described in Patent Literatures 1 to 3, the molecular weight of the nodule group that makes the phenol monomer polynuclear is much larger than that of a phenol formaldehyde resin resulting in lowering of a functional group density, but in any of them, the remedial effect on flexibility is so small that these measures fail to realize a sufficiently satisfactory toughness in the cured product.

An object of the present invention is to provide a novel polyhydric phenol resin which achieves a cured product exhibiting a favorable toughness.

### MEANS FOR SOLVING PROBLEM

As a result of intensive studies, the present inventors have found that the polyhydric phenol resin having the following configuration can achieve a cured product exhibiting a favorable toughness, thereby completing the present invention.

That is, the present invention includes the following contents.
<1> A polyhydric phenol resin (X) containing a polydiene skeleton, the polyhydric phenol resin (X) comprising
   a structural unit represented by the following formula (1) : 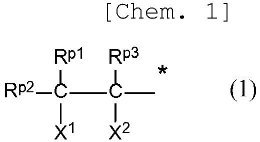 (in the formula (1),
   R^{p1} and R^{p3} each independently represent a hydrogen atom, a methyl group, or an ethyl group,
   R^{p2} represents a hydrogen atom, a methyl group, or a bond,
   one of X¹ and X² represents a hydroxy group, and the other represents a monovalent group represented by the following formula (2), and
   * represents a bond, where the C-C bond structure in the formula (1) is a part of the polydiene skeleton 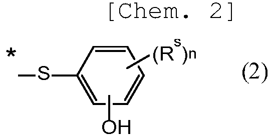 in the formula (2),
   R^{S} each independently represents a substituent,
   * represents a bond, and
   n represents a number of 0 to 4).
<2> The polyhydric phenol resin (X) according to <1>, comprising
   a structural unit A represented by the following formula (A), and
   one or more of a structural unit B selected from a structural unit B1 represented by the following formula (B1) and a structural unit B2 represented by the following formula (B2): 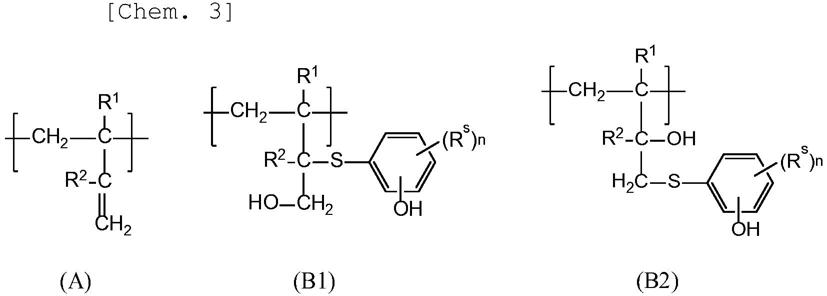 (in the formulas,
   R¹ and R² each independently represent a hydrogen atom, a methyl group, or an ethyl group, and
   R^{S} and n are the same as above).
<3> The polyhydric phenol resin (X) according to <1> or <2>, further comprising a structural unit C represented by the following formula (C): 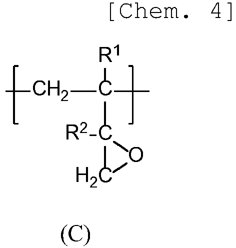 (in the formula, R¹ and R² each independently represent a hydrogen atom, a methyl group, or an ethyl group).
<4> The polyhydric phenol resin (X) according to <2> or <3>, wherein a molar ratio of the structural unit A to the structural unit B (structural unit A : structural unit B) is in a range of 15:85 to 85:15.
<5> The polyhydric phenol resin (X) according to <3> or <4>, wherein a molar ratio of the structural unit B to the structural unit C (structural unit B : structural unit C) is in a range of 20:80 to 100:0.
<6> The polyhydric phenol resin (X) according to any one of <1> to <5>, wherein the polydiene skeleton is a polybutadiene skeleton.
<7> The polyhydric phenol resin (X) according to any one of <1> to <6>, wherein a phenolic hydroxy equivalent is in a range of 200 to 1000 g/eq.
<8> The polyhydric phenol resin (X) according to any one of <3> to <7>, wherein an epoxy equivalent is 3000 g/eq. or more.
<9> The polyhydric phenol resin (X) according to any one of <3> to <8>, wherein a molar ratio of an epoxy group to a phenolic hydroxy group (epoxy group : phenolic hydroxy group) is in a range of 80:20 to 0:100.
<10> The polyhydric phenol resin (X) according to any one of <1> to <9>, wherein the polyhydric phenol resin is a reaction product of an epoxy-modified polydiene compound (x1) with a mercaptophenol compound (x2).
<11> The polyhydric phenol resin (X) according to <10>, wherein the epoxy-modified polydiene compound (x1) comprises a structure represented by the following formula (x1) : 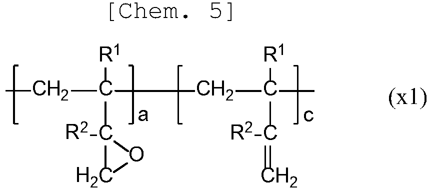 (in the formula,
   R¹ and R² each independently represent a hydrogen atom, a methyl group, or an ethyl group, and
   a and c represent an average number of each structural unit).
<12> The polyhydric phenol resin (X) according to <10> or <11>, wherein an epoxy equivalent of the epoxy-modified polydiene compound (x1) is in a range of 150 to 500 g/eq.
<13> The polyhydric phenol resin (X) according to any one of <10> to <12>, wherein a reaction molar ratio of an epoxy group in the epoxy-modified polydiene compound (x1) to the mercaptophenol compound (x2) (epoxy group : mercaptophenol compound) is in a range of 100:10 to 100:100.
<14> The polyhydric phenol resin (X) according to any one of <10> to <13>, wherein a content of an unreacted mercaptophenol compound (x2) is 10% by mass or less.
<15> A method for producing the polyhydric phenol resin (X) according to any one of <1> to <14>, the method comprising causing an epoxy-modified polydiene compound (x1) to react with a mercaptophenol compound (x2).
<16> The method for producing the polyhydric phenol resin (X) according to claim 15, wherein a reaction temperature is in a range of 30 to 150°C.
<17> The method for producing the polyhydric phenol resin (X) according to <15> or <16>, wherein a reaction catalyst is not used substantially.
<18> A resin composition comprising the polyhydric phenol resin (X) according to any one of <1> to <14>.
<19> The resin composition according to <18>, wherein the resin composition is a thermosetting resin composition or a photo-curable resin composition.
<20> The resin composition according to <18> or <19>, further comprising a thermosetting resin.
<21> The resin composition according to any one of <18> to <20>, further comprising an inorganic filler.
<22> The resin composition according to any one of <18> to <21>, wherein the resin composition is for an insulating layer of a printed wiring board.
<23> The resin composition according to any one of <18> to <21>, wherein the resin composition is for sealing semiconductor.
<24> A resin sheet comprising a support and a layer of the resin composition according to any one of <18> to <23> formed on the support.
<25> The resin sheet according to <24>, wherein the support is a thermoplastic resin film or metal foil.
<26> A prepreg formed by impregnating a sheet-like fiber substrate with the resin composition according to any one of <18> to <23>.
<27> A cured product of the resin composition according to any one of <18> to <23>.
<28> A printed wiring board comprising an insulating layer formed of a cured product of the resin composition according to any one of <18> to <22>.
<29> A semiconductor chip package comprising a sealing layer formed of a cured product of the resin composition according to any one of <18> to <21>, <23>.
<30> The semiconductor chip package according to <29>, wherein the semiconductor chip package is a fan-out type package.
<31> A semiconductor device comprising the printed wiring board according to <28> or comprising the semiconductor chip package according to <29> or <30>.

### EFFECT OF THE INVENTION

According to the present invention, it is possible to provide a novel polyhydric phenol resin which achieves a cured product exhibiting a favorable toughness.

### BRIEF DESCRIPTION OF DRAWINGS

FIG. 1a is the ¹H-NMR spectrum of the polyhydric phenol resin (1) in Example 1.
FIG. 1b is the ¹³C-NMR spectrum of the polyhydric phenol resin (1) in Example 1.
FIG. 1c is the GPC chart of the polyhydric phenol resin (1) in Example 1.
FIG. 1d is the IR chart of the polyhydric phenol resin (1) in Example 1.
FIG. 2a is the GPC chart of the polyhydric phenol resin (2) in Example 2.
FIG. 2b is the IR chart of the polyhydric phenol resin (2) in Example 2.
FIG. 3a is the GPC chart of the polyhydric phenol resin (3) in Example 3.
FIG. 3b is the IR chart of the polyhydric phenol resin (3) in Example 3.

### EMBODIMENT FOR CARRYING OUT THE INVENTION

### <Explanation of Terms>

In the present specification, the term "optionally having a substituent" with respect to a compound or group means both a case where a hydrogen atom of the compound or group is not substituted with a substituent and a case where a part or all of the hydrogen atoms of the compound or group are substituted with a substituent.

In the present specification, the term "substituent" means, unless otherwise specifically mentioned, a halogen atom, an alkyl group, an alkenyl group, an alkynyl group, alkapolyenyl group, a cycloalkyl group, a cycloalkenyl group, an alkoxy group, a cycloalkyloxy group, an aryl group, an aryloxy group, an arylalkyl group, an arylalkoxy group, a monovalent heterocyclic group, an alkylidene group, an amino group, a silyl group, an acyl group, an acyloxy group, a carboxy group, a sulfo group, a cyano group, a nitro group, a hydroxy group, a mercapto group, and an oxo group.

Illustrative examples of the halogen atom used as the substituent may include a fluorine atom, a chlorine atom, a bromine atom, and an iodine atom. The alkyl group used as the substituent may be linear or branched. The number of the carbon atom in the alkyl group is preferably 1 to 12, more preferably 1 to 6, and still more preferably 1 to 3. The alkenyl group used as the substituent may be linear or branched. The number of the carbon atom in the alkenyl group is preferably 2 to 12, more preferably 2 to 6, and still more preferably 2 or 3. The alkynyl group used as the substituent may be linear or branched. The number of the carbon atom in the alkynyl group is preferably 2 to 12, more preferably 2 to 6, and still more preferably 2 or 3. The alkapolyenyl group used as the substituent may be linear or branched, and the number of the double bond therein is preferably 2 to 6, more preferably 2 to 4, and still more preferably 2. The number of the carbon atom in the alkapolyenyl group is preferably 3 to 20, more preferably 3 to 14, and still more preferably 3 to 12, or 3 to 6. The number of the carbon atom in the cycloalkyl group used as the substituent is preferably 3 to 12, and more preferably 3 to 6. The number of the carbon atom in the cycloalkenyl group used as the substituent is preferably 3 to 12, and more preferably 3 to 6. The alkoxy group used as the substituent may be linear or branched. The number of the carbon atom in the alkoxy group is preferably 1 to 12, and more preferably 1 to 6. The number of the carbon atom in the cycloalkyloxy group used as the substituent is preferably 3 to 12, and more preferably 3 to 6. The aryl group used as the substituent is a group obtained by removing one hydrogen atom on an aromatic ring from an aromatic hydrocarbon. The number of the carbon atom in the aryl group used as the substituent is preferably 6 to 14, and more preferably 6 to 10. The number of the carbon atom in the aryloxy group used as the substituent is preferably 6 to 14, and more preferably 6 to 10. The number of the carbon atom in the arylalkyl group used as the substituent is preferably 7 to 15, and more preferably 7 to 11. The number of the carbon atom in the arylalkoxy group used as the substituent is preferably 7 to 15, and more preferably 7 to 11. The monovalent heterocyclic group used as the substituent refers to a group obtained by removing one hydrogen atom from a heterocyclic ring of a heterocyclic compound. The number of the carbon atom in the monovalent heterocyclic group is preferably 3 to 15, and more preferably 3 to 9. The alkylidene group used as the substituent refers to a group in which two hydrogen atoms are removed from the same carbon atom of an alkane. The number of the carbon atom in the alkylidene group is preferably 1 to 12, more preferably 1 to 6, and still more preferably 1 to 3. The acyl group used as the substituent is the group represented by the formula: -C(=O)-R (in the formula, R is an alkyl group or an aryl group), and the acyloxy group used as the substituent refers to the group represented by the formula: -O-C(=O)-R (in the formula, R is an alkyl group or an aryl group). The alkyl group represented by R may be linear or branched. Illustrative examples of the aryl group represented by R may include a phenyl group, a naphthyl group, and an anthracenyl group. The number of the carbon atom in the acyl group and the acyloxy group is preferably 2 to 13, and more preferably 2 to 7. The above-mentioned substituent may further have a substituent (hereinafter, sometimes referred to as a "secondary substituent"). As the secondary substituent, the same substituents as those described above may be used, unless otherwise specified.

In the present specification, "polydiene skeleton" means the skeleton that is formed by diene-polymerization of a conjugated diene compound such as 1,3-butadiene, isoprene (2-methyl-1,3-butadiene), 1,3-pentadiene, 1,3-hexadiene, 2,3-dimethyl-1,3-butadiene, 2-ethyl-1,3-butadiene, 2-methyl-1,3-pentadiene, 3-methyl-1,3-pentadiene, and 4-methyl-1,3-pentadiene. Illustrative examples of the butadiene-derived polydiene skeleton may include a cis-1,4-bond type polydiene skeleton, a trans-1,4-bond type polydiene skeleton, and a 1,2-bond type polydiene skeleton. Illustrative examples of the isoprene-derived polydiene skeleton may includes a cis-1,4-bond type polydiene skeleton, a trans-1,4-bond type polydiene skeleton, a 1,2-bond type polydiene skeleton, and a 3,4-bond type polydiene skeleton. Hereinafter, the polydiene skeleton may be identified in accordance with the conjugated diene compound from which it is derived, such as "polybutadiene skeleton" for the butadiene-derived polydiene skeleton, "polyisoprene skeleton" for the isoprene-derived polydiene skeleton, and "polypentadiene skeleton" for the pentadiene-derived polydiene skeleton.

In the present specification, the "polydiene compound" refers to the compound having the polydiene skeleton. Here, the polydiene compound usually has a plurality of the polydiene skeletons such as a cis-1,4 bond type, a trans-1,4 bond type, a 1,2 bond type, and (in the case of isoprene, etc.) a 3,4-bond type. More suitable embodiments achieving the advantageous effects of the present invention will be described later.

In the present specification, the "epoxy-modified polydiene compound" refers to the compound in which at least a part of the carbon-carbon double bond moiety of the polydiene compound is changed to an epoxy structure.

In the present specification, the "mercaptophenol compound" refers to the phenol compound having a thiol group (SH-). In the mercaptophenol compound, the benzene ring may have additionally another substituent as long as it has a thiol group and a hydroxy group.

Hereinafter, the present invention will be described in detail with reference to preferred embodiments thereof. However, the present invention is not limited to the embodiments and examples described below. The present invention may be optionally modified for implementation without departing from the scope of claims of the present invention and the scope of equivalents thereof.

### [Polyhydric phenol Resin (X)]

The polyhydric phenol resin (X) of the present invention is a polyhydric phenol resin containing a polydiene skeleton. The polyhydric phenol resin (X) of the present invention is characterized in that it contains a structural unit represented by the following formula (1) (hereinafter also referred to as "structural unit (1)"). 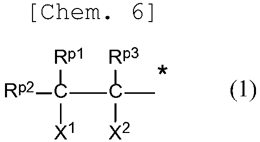 (In the formula (1),
R^{p1} and R^{p3} each independently represent a hydrogen atom, a methyl group, or an ethyl group,
R^{p2} represents a hydrogen atom, a methyl group, or a bond,
one of X¹ and X² represents a hydroxy group, the other represents a monovalent group represented by the formula (2) below, and
* represents a bond. Here, the C-C bond structure in the formula (1) is a part of the polydiene skeleton. 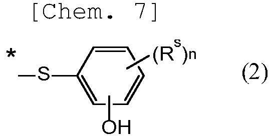 In the formula (2),
   R^{S} each independently represents a substituent,
   * represents a bond, and
   n represents a number of 0 to 4.)

The polyhydric phenol resin (X) of the present invention containing the structural unit (1) in addition to the polydiene skeleton may achieve a cured product exhibiting a favorable toughness. As will be described later, the polyhydric phenol resin (X) is synthesized by reacting an epoxy group of the epoxy-modified polydiene compound with a thiol group of the mercaptophenol compound. The structural unit (1) represents a phenol-modified moiety in which the epoxy group of the epoxy-modified polydiene compound is reacted with the thiol group of the mercaptophenol compound. For example, in the 1,2-bond type polydiene skeleton, the structural unit (1) (in the formula, R^{p2} represents a hydrogen atom or a methyl group) is included in the side chain portion thereof, and in the cis-1,4-bond type or the trans-1,4-bond type polydiene skeleton, the structural unit (1) (in the formula, R^{p2} represents a bond) is included in the main chain portion thereof.

In the structural unit (1), one of X¹ and X² represents a hydroxy group and the other represents a monovalent group represented by the formula (2). In the reaction between the epoxy group of the epoxy-modified polydiene compound and the thiol group of the mercaptophenol compound, isomers are produced depending on the mode of the cleavage of the epoxy group. For example, when the cleavage of the epoxy group takes place between the carbon atom on the left side described in the formula (1) and the oxygen atom, it results in the structural unit (1) in which X¹ is a monovalent group represented by the formula (2) and X² is a hydroxy group. When the cleavage of the epoxy group takes place between the carbon atom on the right side described in the formula (1) and the oxygen atom, it results in the structural unit (1) in which X¹ is a hydroxy group and X² is a monovalent group represented by the formula (2) (with regard to the structure before the cleavage of the epoxy group, see the structural units C and C2 to be described later).

In the formula (1), R^{p1} and R^{p3} each independently represent a hydrogen atom, a methyl group, or an ethyl group, depending on the epoxy-modified polydiene compound used as the raw material thereof. For example, when the epoxy-modified polybutadiene compound is used, regardless of whether it is a 1,2-bond type, a cis-1,4-bond type, or a trans-1,4-bond type polydiene skeleton, R^{p1} and R^{p3} both represent a hydrogen atom. For example, when the epoxy-modified poly(2-methyl-1,3-butadiene) compound, i.e., the epoxy-modified polyisoprene compound, is used, in the 1,2-bond type polydiene skeleton, R^{p1} and R^{p3} both represent a hydrogen atom, in the cis-1,4-bond type or the trans-1,4-bond type polydiene skeleton, R^{p1} represents a methyl group and R^{p3} represents a hydrogen atom, and in the 3,4-bond type polydiene skeleton, R^{p1} represents a hydrogen atom and the R^{p3} represents a methyl group. For example, when the epoxy-modified poly(2-ethyl-1,3-butadiene) compound is used, in the 1,2-bond type polydiene skeleton, R^{p1} and R^{p3} both represent a hydrogen atom, in the cis-1,4-bond type or the trans-1,4-bond type polydiene skeleton, R^{p1} represents an ethyl group and R^{p3} represents a hydrogen atom, and in the 3,4-bond type polydiene skeleton, R^{p1} represents a hydrogen atom and the R^{p3} represents an ethyl group.

In the formula (1), R^{p2} represents a hydrogen atom, a methyl group, or a bond in accordance with the epoxy-modified polydiene compound used as the raw material and with the form of the polydiene skeleton. For example, in the case that the epoxy-modified polybutadiene compound or the epoxy-modified polyisoprene compound is used, in the 1,2-bond type polydiene skeleton or the 3,4-bond type polydiene skeleton, R^{p2} represents a hydrogen atom, and in the cis-1,4-bond type polydiene skeleton or the trans-1,4-bond type polydiene skeleton, R^{p2} represents a bond. In the case that the epoxy-modified polypentadiene compound is used, in the 1,2-bond type polydiene skeleton, R^{p2} represents a methyl group.

In the formula (2), R^{S} represents a substituent. The substituent represented by R^{S} is the same as those described before. Among them, from the viewpoint of achieving the advantageous effects of the present invention furthermore, one or more of the group selected from a halogen atom, an alkyl group, and an aryl group are preferable, and one or more of the group selected from a fluorine atom, an alkyl group having 1 to 6 carbon atoms, and an aryl group having 6 to 10 carbon atoms are more preferable.

In the formula (2), n represents a number of 0 to 4, preferably 0 to 3, more preferably 0 to 2, and still more preferably 0 or 1.

From the viewpoint of achieving the cured product that exhibits a further favorable toughness, it is preferable that the polyhydric phenol resin (X) contains the structural unit (1) such that the phenolic hydroxy equivalent thereof is preferably 200 g/eq. or more, more preferably 220 g/eq. or more, and still more preferably 240 g/eq. or more, 250 g/eq. or more, 260 g/eq. or more, or 280 g/eq. or more. It is preferable that the polyhydric phenol resin (X) contains the structural unit (1) such that the upper limit of the phenolic hydroxy equivalent thereof is preferably 1000 g/eq. or less, more preferably 900 g/eq. or less, and still more preferably 800 g/eq. or less, 750 g/eq. or less, 700 g/eq. or less, 680 g/eq. or less, 660 g/eq. or less, or 650 g/eq. or less. Accordingly, in one preferable embodiment, the phenolic hydroxy equivalent of the polyhydric phenol resin (X) is 200 to 1000 g/eq. The phenolic hydroxy equivalent of the polyhydric phenol resin (X) is the mass of the polyhydric phenol resin (X) containing one equivalent of the phenolic hydroxy group, and this may be measured by the method in accordance with JIS K0070.

From the viewpoint of realizing the polyhydric phenol resin (X) that achieves the cured product exhibiting favorable properties in both the flexural toughness and the tensile toughness, the epoxy-modified polydiene compound used as the raw material preferably includes the polydiene structures formed by the diene-polymerization of one or more of the conjugated diene selected from 1,3-butadiene, isoprene (i.e., 2-methyl-1,3-butadiene), 2,3-dimethyl-1,3-butadiene, and 2-ethyl-1,3-butadiene, more preferably it includes the polydiene structures formed by the diene-polymerization of one or more of the conjugated diene selected from 1,3-butadiene and isoprene (i.e., 2-methyl-1,3-butadiene), and still more preferably it includes the polydiene structures formed by the diene-polymerization of 1,3-butadiene. In other words, the polyhydric phenol resin (X) preferably includes one or more of the polydiene skeleton selected from a polybutadiene skeleton, a polyisoprene skeleton, a poly(2,3-dimethyl-1,3-butadiene) skeleton, and a poly(2-ethyl-1,3-butadiene) skeleton, more preferably it includes one or more of the polydiene skeleton selected from a polybutadiene skeleton and a polyisoprene skeleton, and still more preferably it includes a polybutadiene skeleton as the polydiene skeleton.

From the viewpoint of achieving the cured product that exhibits favorable properties in both the flexural toughness and the tensile toughness, it is preferable that the polyhydric phenol resin (X) contains the 1,2-bond type or the 3,4-bond type polydiene skeleton. The 3,4-bond type polydiene skeleton may be contained when the epoxy-modified polydiene compound used as the raw material contains the polydiene skeleton formed by diene-polymerization of the conjugated diene compound having a substituent at the second carbon atom and not at the third carbon atom such as isoprene or 2-ethyl-1,3-butadiene, or having different substituents at the second and the third carbon atoms. In this regard, in the polydiene skeleton formed by diene-polymerization of the conjugated diene compound that has no substituent on the second carbon atom and the third carbon atom such as 1,3-butadiene, or the conjugated diene compound that has the same substituent on the second carbon atom and the third carbon atom such as 2,3-dimethyl-1,3-butadiene, the 1,2-bond type polydiene skeleton and the 3,4-bond type polydiene skeleton are identical, and therefore, these both shall be referred to as the 1,2-bond type polydiene skeleton.

From the viewpoint of achieving the cured product that exhibits further favorable properties in both the flexural toughness and the tensile toughness, when the total amount of the polydiene skeletons contained in the polyhydric phenol resin (X) is defined as 100% by mole, the total content of the 1,2-bond type polydiene skeleton and the 3,4-bond type polydiene skeleton is preferably 50% by mole or more, more preferably 60% by mole or more, and still more preferably 65% by mole or more, 70% by mole or more, or more than 70% by mole. The upper limit of the total content of the 1,2-bond type and 3,4-bond type polydiene skeletons may be 100% by mole, and it may also be, for example, 99.9% by mole or less, 99.5% by mole or less, 99% by mole or less, 98% by mole or less, or the like.

In the polyhydric phenol resin (X) of the present invention, the polydiene skeleton may include one or more of the polydiene structure selected from the group consisting of the cis-1,4-bond type polydiene skeleton and the trans-1,4-bond type polydiene skeleton in addition to the 1,2-bond type polydiene skeleton and the 3,4-bond type polydiene skeleton.

In one preferable embodiment, when the total amount of the polydiene skeletons contained in the polyhydric phenol resin (X) of the present invention is defined as 100% by mole, the total content of the 1,2-bond type polydiene skeleton and the 3,4-bond type polydiene skeleton is 70% by mole or more, and the balance (remaining part) includes one or more of the skeleton selected from the group consisting of the cis-1,4-bond type polydiene skeleton and the trans-1,4-bond type polydiene skeleton.

The polyhydric phenol resin (X) of the present invention may include the epoxy group derived from the epoxy-modified polydiene compound used as the raw material. In other words, when producing the polyhydric phenol resin (X) of the present invention, it is not necessary to convert all of the epoxy groups in the epoxy-modified polydiene compound used as the raw material into the structural unit (1) by reacting with the mercaptophenol compound. So, the polyhydric phenol resin (X) of the present invention may include an unreacted epoxy group. The epoxy group is included in the side chain portion in the case of the 1,2-bond type or the 3,4-bond type polydiene skeleton (see the structural unit C to be described later) and in the main chain portion in the case of the cis-1,4-bond type or the trans-1,4-bond type polydiene skeleton (see the structural unit C2 to be described later).

When the polyhydric phenol resin (X) contains the epoxy group, the epoxy equivalent of the polyhydric phenol resin (X) is preferably 500 g/eq. or more, more preferably 1000 g/eq. or more, 1500 g/eq. or more, 2000 g/eq. or more, or 2500 g/eq. or more, and still more preferably 3000 g/eq. or more, 3500 g/eq. or more, 4000 g/eq. or more, 4500 g/eq. or more, or 5000 g/eq. or more. When the polyhydric phenol resin (X) contains the epoxy group, the upper limit of the epoxy equivalent of the polyhydric phenol resin (X) is not particularly restricted, and it may be, for example, 500000 g/eq. or less, 400000 g/eq. or less, 300000 g/eq. or less. Accordingly, in one embodiment, the epoxy equivalent of the polyhydric phenol resin (X) of the present invention is 3000 g/eq. or more. The epoxy equivalent of the polyhydric phenol resin (X) is the mass of the polyhydric phenol resin (X) containing one equivalent of the epoxy group. This may be measured in accordance with JIS K7236.

In the polyhydric phenol resin (X) of the present invention, from the viewpoint of achieving the advantageous effects of the present invention, the molar ratio of the epoxy group to the phenolic hydroxy group (epoxy group : phenolic hydroxy group) is preferably in the range of 90:10 to 0:100, more preferably in the range of 80:20 to 0:100, and still more preferably in the range of 70: 30 to 0:100, 60:40 to 0:100, 50:50 to 0:100, 40:60 to 0:100, 30:70 to 0:100, or 20:80 to 0:100. As described above, it is not necessary that all of the epoxy groups react with the mercaptophenol compound to be changed to the phenol-modified moiety (convert to the structural unit (1)), so that the upper limit of the above preferable range (focusing on the phenolic hydroxy group) may be 0.1:99.9 or less, 0.5:99.5 or less, 1:99 or less, 2:98 or less, or the like. Accordingly, in one embodiment, the molar ratio of the epoxy group to the phenolic hydroxy group (epoxy group : phenolic hydroxy group) is in the range of 80:20 to 0:100.

As described above, all the mercaptophenol compound used as the raw material do not have to be subjected to the reaction, and thus, the polyhydric phenol resin (X) of the present invention may include the mercaptophenol compound that is unreacted (preferable embodiment will be described later). For example, the polyhydric phenol resin (X) of the present invention may include the unreacted mercaptophenol compound with the amount of preferably 10% by mass or less, more preferably 8% by mass or less, and still more preferably 6% by mass or less, or 5% by mass or less, when the amount of the polyhydric phenol resin (X) is defined as 100% by mass. The lower limit of the content of the unreacted mercaptophenol compound may be 0% by mass. Accordingly, in one embodiment, the content of the unreacted mercaptophenol compound is 10% by mass or less.

Hereinafter, from the viewpoint of achieving the cured product that exhibits favorable properties both in the flexural toughness and the tensile toughness, an especially preferable embodiment will be described.

In one preferable embodiment, the polyhydric phenol resin (X) includes
a structural unit A represented by the following formula (A), and
one or more of a structural unit B selected from a structural unit B1 represented by the following formula (B1) and a structural unit B2 represented by the following formula (B2). 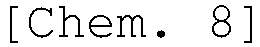 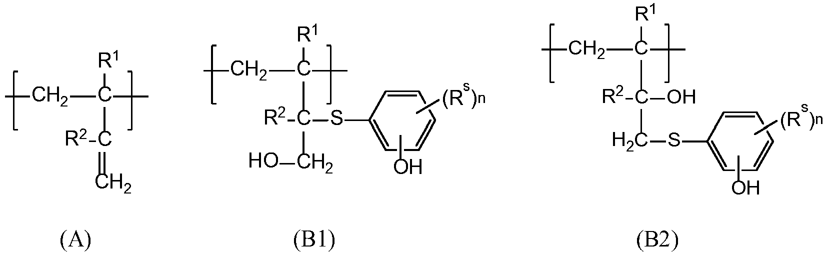
(In the formula,
R¹ and R² each independently represent a hydrogen atom, a methyl group, or an ethyl group, and
R^{S} and n are the same as above.)

The structural unit A is the structural unit that constitutes the 1,2-bond type or the 3,4-bond type polydiene skeleton. For example, when the epoxy-modified polydiene compound used as the raw material has a polydiene skeleton formed by diene-polymerization of 1,3-butadiene, the structural unit A is the structural unit that constitutes the 1,2-bond type polydiene skeleton in which R¹ and R² both represent a hydrogen atom. For example, when the epoxy-modified polydiene compound used as the raw material has a polydiene skeleton formed by diene-polymerization of isoprene, the structural unit A is the structural unit that constitutes the 1,2-bond type polydiene skeleton in which R¹ represents a methyl group and R² represents a hydrogen atom, or the structural unit that constitutes the 3,4-bond type polydiene skeleton in which R¹ represents a hydrogen atom and R² represents a methyl group. When the epoxy-modified polydiene compound used as the raw material has the polydiene skeleton formed by diene-polymerization of 2-ethyl-1,3-butadiene, the structural unit A is the structural unit that constitutes the 1,2-bond type polydiene skeleton in which R¹ represents an ethyl group and R² represents a hydrogen atom, or the structural unit that constitutes the 3,4-bond type polydiene skeleton in which R¹ represents a hydrogen atom and R² represents an ethyl group.

From the viewpoint of achieving the cured product that exhibits favorable properties both in the flexural toughness and the tensile toughness, R¹ and R² each independently represent preferably a hydrogen atom or a methyl group.

The structural unit B is the structural unit that constitutes the 1,2-bond type or the 3,4-bond type polydiene skeleton, and it represents the phenol-modified moiety that is formed by the reaction between the epoxy group of the epoxy-modified polydiene compound used as the raw material and the thiol group of the mercaptophenol compound.

As described above, the polyhydric phenol resin (X) is characterized by containing the structural unit (1). The structural unit B includes the structural unit (1) in the side chain portion, regardless of the structural unit B1 or B2. In the structural units B1 and B2, the bonding sites of the monovalent group represented by the formula (2) and the hydroxy group are different. This difference in the bonding site is due to the difference in the mode of the cleavage of the epoxy group when the epoxy group of the epoxy-modified polydiene compound reacts with the mercaptophenol compound, as described above. In this regard, the structural unit B1 corresponds to the case where the cleavage takes place between the second carbon atom from the bottom as illustrated here and the oxygen in the side chain portion, and the structural unit B2 corresponds to the case where the cleavage takes place between the lowest carbon atom as illustrated here and the oxygen atom in the side chain portion (for the structure before the cleavage, see the structural unit C to be described later).

The R¹ and R² in the structural unit B are the same as those described for the structural unit A, and they are dependent on the polydiene skeleton of the epoxy-modified polydiene compound used as the raw material.

The R^{S} and n in the structural unit B, including their preferable embodiments and values, are the same as those described for the monovalent group represented by the formula (2).

From the viewpoint of achieving the cured product that exhibits the favorable toughnesses, the molar ratio of the structural unit A to the structural unit B (structural unit A : structural unit B) in the polyhydric phenol resin (X) of the present invention is preferably in the range of 15:85 to 90:10, more preferably in the range of 15:85 to 85:15, and still more preferably in the range of 15:85 to 80:20. The lower limit of the molar ratio (focusing on the structural unit A) is more preferably 20:80 or more, still more preferably 30:70 or more, and further still more preferably 40:60 or more, 50:50 or more, 60:40 or more, 65:35 or more, or 70:30 or more. Accordingly, in one embodiment, the molar ratio of the structural unit A to the structural unit B (structural unit A : structural unit B) in the polyhydric phenol resin (X) is in the range of 15:85 to 85:15.

As described above, the polyhydric phenol resin (X) of the present invention may include the epoxy group derived from the epoxy-modified polydiene compound used as the raw material. In one embodiment, the polyhydric phenol resin (X) of the present invention includes a structural unit C represented by the following formula (C). 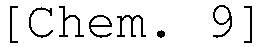 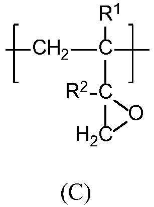 (In the formula, R¹ and R² are the same as described above.)

The structural unit C is the structural unit that constitutes the 1,2-bond type or the 3,4-bond type polydiene skeleton and represents the epoxy-modified moiety of the epoxy-modified polydiene compound used as the raw material, i.e., the unreacted epoxy-modified moiety not subjected to the reaction with the mercaptophenol compound.

The R¹ and R² included in the structural unit C are the same as those described for the structural unit A, and they are dependent on the polydiene skeleton of the epoxy-modified polydiene compound used as the raw material.

From the viewpoint of achieving the cured product that exhibits the favorable toughnesses, the molar ratio of the structural unit B to the structural unit C (structural unit B : structural unit C) in the polyhydric phenol resin (X) of the present invention is preferably in the range of 10:90 to 100:0, more preferably 20:80 to 100:0, and still more preferably 30:70 to 100:0, 40:60 to 100:0, 50:50 to 100:0, 60:40 to 100:0, 70:30 to 100:0, or 80:20 to 100:0. The upper limit of the molar ratio (focusing on the structural unit B) may be 99.9:0.1 or less, 99.5:0.5 or less, 99:1 or less, 98:2 or less, or the like. Accordingly, in one embodiment, the molar ratio of the structural unit B to the structural unit C (structural unit B : structural unit C) in the polyhydric phenol resin (X) is in the range of 20:80 to 100:0.

The polyhydric phenol resin (X) of the present invention may include another structural unit in addition to the structural units A, B and C. Illustrative examples of the another structural unit may include structural units that constitutes the cis-1,4-bond type or the trans-1,4-bond type polydiene skeleton.

For example, the polyhydric phenol resin (X) of the present invention may further include
a structural unit A2 represented by the following formula (A2), and
one or more of the structural unit B2 selected from a structural unit B2-1 represented by the following formula (B2-1) and a structural unit B2-2 represented by the following formula (B2-2). 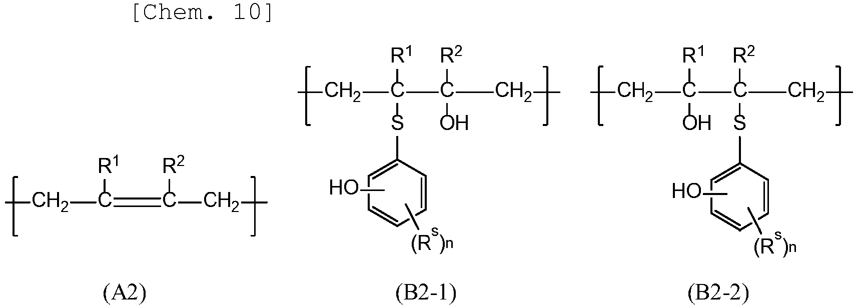 (In the formula, R¹, R², R^{S} and n are the same as those described above.)

The structural units A2 and B2 are the structural units that constitute the cis-1,4-bond type or the trans-1,4-bond type polydiene skeleton. In the formulas (A2), (B2-1) and (B2-2), the cis and trans isomers are described without distinction in the geometric isomers thereof.

The R¹ and R² in the structural units A2 and B2 are the same as those described for the structural unit A, and they are dependent on the polydiene skeleton of the epoxy-modified polydiene compound used as the raw material.

For example, when the epoxy-modified polydiene compound used as the raw material has the polydiene skeleton formed by diene-polymerization of 1,3-butadiene, the structural unit A2 is the structural unit that constitutes the cis-1,4-bond type or the trans-1,4-bond type polydiene skeleton in which both the R¹ and the R² represent a hydrogen atom. For example, when the epoxy-modified polydiene compound used as the raw material has the polydiene skeleton formed by diene-polymerization of isoprene, the structural unit A2 is the structural unit that constitutes the cis-1,4-bond type or the trans-1,4-bond type polydiene skeleton, in which the R¹ is a methyl group and the R² is a hydrogen atom.

The structural unit B2 indicates the phenol-modified moiety that is resulted by the reaction of the epoxy group of the epoxy-modified polydiene compound used as the raw material with the thiol group of the mercaptophenol compound. As described above, the polyhydric phenol resin (X) contains the structural unit (1). The structural unit B2 includes the structural unit (1) in the main chain portion, regardless of the structural unit B2-1 or B2-2. In the structural units B2-1 and B2-2, the bonding sites of the monovalent group represented by the formula (2) and the hydroxy group are different. This difference in the bonding site is due to the difference in the mode of the cleavage of the epoxy group when the epoxy group of the epoxy-modified polydiene compound reacts with the mercaptophenol compound, as described above. In this regard, the structural unit B2-1 corresponds to the case where the cleavage takes place between the second carbon atom from the left as illustrated here and the oxygen atom in the main chain portion, and structural unit B2-2 corresponds to the case where the cleavage takes place between the third carbon atom from the left as illustrated here and the oxygen atom in the main chain portion (for the structure before the cleavage, see the structural unit C2 to be described later).

The polyhydric phenol resin (X) of the present invention may further include a structural unit C2 represented by the following formula (C2). 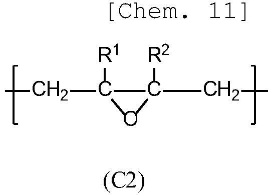 (In the formula, R¹ and R² are the same as those described above.)

The structural unit C2 represents the epoxy-modified moiety of the epoxy-modified polydiene compound when the epoxy-modified polydiene compound having the cis-1,4-bond type or the trans-1,4-bond type polydiene skeleton is used as the raw material, i.e., the unreacted epoxy-modified moiety not subjected to the reaction with the mercaptophenol compound.

The R¹ and the R² in the structural unit C2 are the same as those described above for the structural unit A, and they are dependent on the polydiene skeleton of the epoxy-modified polydiene compound used as the raw material.

From the viewpoint of achieving the cured product that exhibits favorable properties both in the flexural toughness and the tensile toughness, when the total amount of the polydiene skeletons included in the polyhydric phenol resin (X) of the present invention is defined as 100% by mole, the total content of the structural units A, B and C is preferably 50% by mole or more, more preferably 60% by mole or more, and still more preferably 65% by mole or more, 70% by mole or more, or more than 70% by mole. The upper limit of the total content of the structural units A, B and C may be 100% by mole, and it may be, for example, 99.9% by mole or less, 99.5% by mole or less, 99% by mole or less, 98% by mole or less, or the like.

In one preferable embodiment, when the total amount of the polydiene skeletons included in the polyhydric phenol resin (X) of the present invention is defined as 100% by mole, the total content of the structural units A, B and C is 70% by mole or more, and the balance includes one or more of the structural unit selected from the group consisting of the structural units A2, B2 and C2.

From the viewpoint of achieving the cured product that exhibits favorable properties both in the flexural toughness and the tensile toughness, the average total number of the structural units A, B and C included per one molecule of the polyhydric phenol resin (X) is preferably 10 or more, more preferably 12 or more, and still more preferably 14 or more, or 15 or more. The upper limit of the average total number of the structural units A, B and C is preferably 100 or less, more preferably 80 or less, and still more preferably 70 or less, 60 or less, 50 or less, or 45 or less. Accordingly, in one embodiment, the average total number of the structural units A, B and C included in one molecule of the polyhydric phenol resin (X) of the present invention is in the range of 10 to 100.

### -Synthesis of polyhydric phenol resin (X)-

The polyhydric phenol resin (X) of the present invention is synthesized by reacting the epoxy group of the epoxy-modified polydiene compound with the thiol group of the mercaptophenol compound.

Accordingly, in one embodiment, the polyhydric phenol resin (X) is a reaction product of
an epoxy-modified polydiene compound (x1) with
a mercaptophenol compound (x2).

### -Epoxy-modified polydiene compound (x1)-

The component (x1) is the epoxy-modified polydiene compound.

The epoxy-modified polydiene compound is as described above. In particular, from the viewpoint of achieving the cured product that exhibits favorable properties in both the flexural toughness and the tensile toughness, it is preferable that the polyhydric phenol resin (X) includes the 1,2-bond type or the 3,4-bond type polydiene skeleton. The preferable range of the total content of the 1,2-bond type and the 3,4-bond type polydiene skeletons, when the total amount of the polydiene skeletons included in the epoxy-modified polydiene compound is defined as 100% by mole, is the same as the range described above for the polyhydric phenol resin (X).

In one preferable embodiment, the epoxy-modified polydiene compound (x1) includes the structure represented by the following formula (x1). 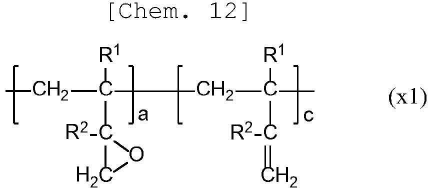 (In the formula,
R¹ and R² are the same as those described above, and
a and c represent the average number of each structural unit.)

As for the epoxy-modified polydiene compound represented by the formula (x1), any epoxy-modified polydiene compound including the 1,2-bond type or the 3,4-bond type polydiene skeleton may be used in accordance with the structure of the intended polyhydric phenol resin (X). Preferable examples of the R¹ and the R² are the same as those described before. For example, when both the R¹ and the R² in the intended polyhydric phenol resin (X) are a hydrogen atom, the epoxy-modified polydiene compound having the polydiene skeleton formed by diene-polymerization (1,2-bonding) of a conjugated diene compound such as 1,3-butadiene that has no substituent on both the second carbon atom and the third carbon atom may be used. When in the intended polyhydric phenol resin (X) the R¹ is a methyl group or an ethyl group and the R² is a hydrogen atom, the epoxy-modified polydiene compound having the polydiene skeleton formed by the diene-polymerization (1,2-bonding) of a conjugated diene compound such as isoprene or 2-ethyl-1,3-butadiene, which has a methyl group or an ethyl group at the second carbon atom and no substituent at the third carbon atom, may be used. When in the intended polyhydric phenol resin (X) the R¹ is a hydrogen atom and the R² is a methyl group or an ethyl group, the epoxy-modified polydiene compound having the polydiene skeleton formed by the diene-polymerization (3,4-bonding) of a conjugated diene compound such as isoprene or 2-ethyl-1,3-butadiene, which has a methyl group or an ethyl group at the second carbon atom and no substituent at the third carbon atom, may be used.

In the formula (x1), a and c represent the average number of each structural unit. For example, when the average total number of the structural units A, B and C included per one molecule of the intended polyhydric phenol resin (X) is in the range of 10 to 100, the epoxy-modified polydiene compound in which the sum of a and c is in the range of 10 to 100 may be used. To adjust the average number of the structural unit A included per one molecule of the polyhydric phenol resin (X), the value of c in the formula (x1) may be adjusted, and to adjust the average number of the structural units B and C included per one molecule of the polyhydric phenol resin (X), the value of a in the formula (x1) may be adjusted. To adjust the molar ratio of the structural unit B and the structural unit C included in the polyhydric phenol resin (X), the degree of the reaction between the epoxy group of the epoxy-modified polydiene compound (x1) and the thiol group of the mercaptophenol compound (x2) to be described later may be adjusted. From the viewpoint of readily realizing the preferable molar ratio of the structural units A, B and C as described above for the polyhydric phenol resin (X), it is preferable that a and c in the formula (x1) satisfies the relationship of 0.1≤a/(a+c)≤0.5.

The epoxy-modified polydiene compound may further include the cis-1,4-bond type or the trans-1,4-bond type polydiene skeleton as long as it includes the structure represented by the formula (x1), as described above.

From the viewpoint of realizing the polyhydric phenol resin (X) that achieves the cured product exhibiting favorable toughnesses, the epoxy equivalent of the epoxy-modified polydiene compound (x1) is preferably 150 g/eq. or more, more preferably 160 g/eq. or more, still more preferably 170 g/eq. or more, or 180 g/eq. or more, and the upper limit thereof is preferably 500 g/eq. or less, more preferably 450 g/eq. or less, still more preferably 400 g/eq. or less, 350 g/eq. or less, 300 g/eq. or less, 280 g/eq. or less, 260 g/eq. or less, or 250 g/eq. or less. Accordingly, in one embodiment, the epoxy equivalent of the epoxy-modified polydiene compound (x1) is in the range of 150 to 500 g/eq.

The epoxy-modified polydiene compound (x1) may be synthesized by modifying at least a part of the carbon-carbon double bond of the polydiene compound to an epoxy structure. Such epoxidation may be performed according to a conventionally known method, such as oxidation of the carbon-carbon double bond using a peracid such as hydrogen peroxide. By adjusting the degree of epoxidation, the ratio of a and c in the formula (x1) may be adjusted.

As for the epoxy-modified polydiene compound (x1), a commercially available product may be used. Illustrative examples of the commercially available product of the epoxy-modified polydiene compound (x1) may include "JP-100" (epoxy equivalent of 200 g/eq.; in the formula (x1), a = 4 to 7, a + c = 16 to 25, both R¹ and R² are a hydrogen atom, and the content of the 1,2-bond type polydiene skeleton is more than 70% by mole) and "JP-200" (epoxy equivalent of 215 g/eq.; in the formula (x1), a = 8 to 11, a + c = 35 to 43, both R¹ and R² are a hydrogen atom, and the content of the 1,2-bond type polydiene skeleton is more than 70% by mole), both being manufactured by Nippon Soda Co., Ltd.

### -Mercaptophenol compound (x2)-

The component (x2) is a mercaptophenol compound.

In accordance with the structure of the intended polyhydric phenol resin (X), any mercaptophenol compound represented by the following formula (x2) may be used. 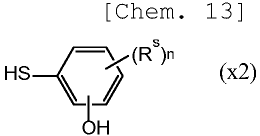 (In the formula, R^{S} and n are the same as those described above.)

Preferable examples and values of the R^{S} and n are the same as those described above. For example, when n in the intended polyhydric phenol resin (X) is 0, a mercaptophenol (p-mercaptophenol, m-mercaptophenol, or o-mercaptophenol) may be used. When n is 1 and the R^{S} is a methyl group in the intended polyhydric phenol resin (X), 4-hydroxy-3-methyl-benzenethiol, 4-hydroxy-2-methyl-benzenethiol, 4-methyl-3-hydroxy-benzenethiol, and the like may be used.

In the reaction of the epoxy-modified polydiene compound (x1) with the mercaptophenol compound (x2), the epoxy group in the component (x1) reacts with the thiol group in the component (x2). At this time, in accordance with the cleavage reaction of the epoxy group of the component (x1), the aforementioned structural units B1 and B2 are formed in the 1,2-bond type or the 3,4-bond type polydiene skeleton, and the aforementioned structural units B2-1 and B2-2 are formed in the cis-1,4-bond type or the trans-1,4-bond type polydiene skeleton. When all of the epoxy groups in the component (x1) do not react thereby leaving the epoxy group unreacted in the resulting polyphenol resin (X), the aforementioned structural unit C remains in the 1,2-bond type or the 3,4-bond type polydiene skeleton, and the aforementioned structural unit C2 remains in the cis-1,4-bond type or the trans-1,4-bond type polydiene skeleton.

From the viewpoint of readily realizing the polyhydric phenol resin (X) that achieves the cured product exhibiting the favorable toughnesses, the reaction molar ratio of the epoxy group in the epoxy-modified polydiene compound (x1) to the mercaptophenol compound (x2) (epoxy group : mercaptophenol compound) is preferably in the range of 100:10 to 100: 100, more preferably in the range of 100:30 to 100:100, and still more preferably in the range of 100:50 to 100:100, 100:60 to 100:100, 100:70 to 100:100, 100:80 to 100:100, or 100:90 to 100:100. Accordingly, in one embodiment, the reaction molar ratio of the epoxy group in the epoxy-modified polydiene compound (x1) to the mercaptophenol compound (x2) (epoxy group : mercaptophenol compound) is in the range of 100:10 to 100:100.

The present invention also provides a method for producing the polyhydric phenol resin (X) (hereinafter also simply referred to as "the production method of the present invention").

Specifically, the production method of the present invention is characterized in that the epoxy-modified polydiene compound (x1) is caused to react with the mercaptophenol compound (x2).

The reaction of the component (x1) with the component (x2), i.e., the reaction between the epoxy group of the component (x1) and the thiol group of the component (x2), may be proceeded in a solvent-free system without using a solvent or in an organic solvent system using an organic solvent. Illustrative examples of the organic solvent used in the condensation reaction may include ketone type solvents such as acetone, methyl ethyl ketone, methyl isobutyl ketone, and cyclohexanone; acetate ester type solvents such as ethyl acetate, butyl acetate, cellosolve acetate, propylene glycol monomethyl ether acetate, and carbitol acetate; carbitol solvents such as cellosolve and butyl carbitol; aromatic hydrocarbon solvents such as toluene and xylene; and amide type solvents such as N,N-dimethylformamide, N,N-dimethylacetamide, and N-methyl-2-pyrrolidone. The organic solvent may be used singly or in a combination of two or more of those described above.

In the reaction of the component (x1) with the component (x2), a reaction catalyst such as a base catalyst may be used, or a reaction catalyst may not be used substantially. The reaction of a thiol compound with an epoxy compound has been known for long, in which a base catalyst such as a tertiary amine is often used to make the reaction smoothly proceed (for example, in the reaction of an alkanethiol with an epoxy compound, a base catalyst is usually used to make the reaction smoothly proceed). In this regard, it was confirmed that the reaction of the epoxy group of the component (x1) with the thiol group of the component (x2) proceeded smoothly without a substantial use of the reaction catalyst. Accordingly, in one embodiment of the production method of the present invention, the reaction catalyst is not used substantially in the reaction of the component (x1) with the component (x2). In the present invention, "the reaction catalyst is not used substantially" means that the amount of the reaction catalyst is 0.01 parts by mass or less, and preferably 0.005 parts by mass or less, or this may be 0.0001 parts by mass or less, when the total amount of the component (x1) and the component (x2) is defined as 100 parts by mass.

The reaction temperature of the component (x1) with the component (x2) is not particularly restricted as long as the reaction proceeds. The reaction temperature may be made in the range of 30 to 150°C. In the production method of the present invention, even when the reaction catalyst is not used substantially, the reaction may be performed at a lower temperature. For example, in the production method of the present invention, the reaction temperature of the component (x1) with the component (x2) may be made 140°C or lower, 120°C or lower, 100°C or lower, or the like.

The reaction time of the component (x1) with the component (x2) is not particularly restricted as long as the structure of the intended polyhydric phenol resin (X) is achieved. For example, this may be made in the range of 30 minutes to 30 hours. In the production method of the present invention, it is possible to make the reaction of the component (x1) with the component (x2) smoothly proceed even when the reaction catalyst is not substantially used. For example, the reaction time of the component (x1) with the component (x2) may be made 20 hours or shorter, 15 hours or shorter, 14 hours or shorter, 12 hours or shorter, or the like.

The production method of the present invention may be performed in a solvent-free system and substantially without using the reaction catalyst. In the reaction of the component (x1) with the component (x2), there are very few byproducts (theoretically no byproducts are produced); thus, the intended polyhydric phenol resin (X) may be produced with a high purity by the reaction of the component (x1) with the component (x2). It has already been mentioned that an unreacted mercaptophenol compound may be included in the obtained polyhydric phenol resin (X), and it has also been mentioned the preferable range of the content of the mercaptophenol compound in such a case.

### [Resin composition]

The polyhydric phenol resin (X) of the present invention may be used to produce a resin composition. The present invention also provides this resin composition.

The resin composition of the present invention includes the polyhydric phenol resin (X) of the present invention. From the viewpoint of achieving the cured product that exhibits the favorable toughnesses, when the amount of the resin components in the resin composition is defined as 100% by mass, the content of the polyhydric phenol resin (X) in the resin composition is preferably 20% by mass or more, more preferably 30% by mass or more, and still more preferably 40% by mass or more, 45% by mass or more, 50% by mass or more, 55% by mass or more, or 60% by mass or more. The upper limit of the content is not particularly restricted. This may be determined in accordance with the properties required for the resin composition, for example, 99.8% by mass or less, 99.6% by mass or less, 99.5% by mass or less, 99.4% by mass or less, or 99.2% by mass or less. In the present invention, the term "resin components" as used with regard to the resin composition refers to nonvolatile components constituting the resin composition other than an inorganic filler to be described later.

### -Cross-linkable resin (Y)-

In addition to the polyhydric phenol resin (X) of the present invention, the resin composition of the present invention may include a cross-linkable resin as a component (Y). The cross-linkable resin of the component (Y) refers to a cross-linkable resin other than the polyhydric phenol resin (X).

The cross-linkable resin (Y) is not particularly restricted as long as this is can be crosslinked in the presence of the polyhydric phenol resin (X). From the viewpoint of achieving the cured product exhibiting the favorable toughnesses, and also from the viewpoint of achieving the cured product exhibiting a favorable insulating property, in combination with the polyhydric phenol resin (X), it is preferable that the cross-linkable resin (Y) is one or more of the resin selected from the group consisting of a thermosetting resin and a radically polymerizable resin.

As for the thermosetting resin and the radically polymerizable resin, known resins used in forming an insulating layer for a printed wiring board and a semiconductor chip package may be used. Hereinafter, the thermosetting resin and the radically polymerizable resin that may be used as the cross-linkable resin will be described.

Illustrative examples of the thermosetting resin may include an epoxy resin, a benzocyclobutene resin, an epoxy acrylate resin, a urethane acrylate resin, a urethane resin, a cyanate resin, a polyimide resin, a benzoxazine resin, an unsaturated polyester resin, a phenol resin, a melamine resin, a silicone resin, and a phenoxy resin. The thermosetting resin may be used singly or in a combination of two or more of those described above. In particular, it is preferable that the cross-linkable resin includes an epoxy resin from the viewpoint of being able to achieve the cured product that exhibits further favorable properties both in the flexural toughness and the tensile toughness in combination with the polyhydric phenol resin (X).

The epoxy resin is not particularly restricted as long as it has one or more (preferably two or more) of the epoxy group per one molecule. Illustrative examples of the epoxy resin may include a bisphenol A type epoxy resin, a bisphenol F type epoxy resin, a bisphenol S type epoxy resin, a bisphenol AF type epoxy resin, a phenol novolac type epoxy resin, a tert-catechol type epoxy resin, a naphthol type epoxy resin, a naphthalene type epoxy resin, a naphthylene ether type epoxy resin, a glycidylamine type epoxy resin, a glycidyl ester type epoxy resin, a cresol novolac type epoxy resin, a biphenyl type epoxy resin, a phenol aralkyl type epoxy resin, a biphenyl aralkyl type epoxy resin, a fluorene skeleton type epoxy resin, a dicyclopentadiene type epoxy resin, an anthracene type epoxy resin, a linear aliphatic epoxy resin, an epoxy resin having a butadiene structure, an alicyclic epoxy resin, a heterocyclic epoxy resin, an epoxy resin having a spirocycle, a cyclohexanedimethanol type epoxy resin, a trimethylol type epoxy resin, and a halogenated epoxy resin. According to the resin composition of the present invention including the polyhydric phenol resin (X), it is possible to achieve the cured product exhibiting the favorable toughnesses regardless of the type of the epoxy resin.

The epoxy resin may be classified into a liquid epoxy resin that is liquid at 20°C (hereinafter referred to as "liquid epoxy resin") and a solid epoxy resin that is solid at 20°C (hereinafter referred to as "solid epoxy resin"). The resin composition of the present invention may include, as the cross-linkable resin, only the liquid epoxy resin, only the solid epoxy resin, or a combination of the liquid epoxy resin and the solid epoxy resin. In the case that the liquid epoxy resin and the solid epoxy resin are included in combination, the blending ratio thereof (liquid:solid) may be made in the range of 20:1 to 1:20 in mass ratio (preferably 10:1 to 1:10, and more preferably 3:1 to 1:3).

The epoxy equivalent of the epoxy resin is preferably 50 g/eq. to 2000 g/eq., more preferably 60 g/eq. to 1000 g/eq., and still more preferably 80 g/eq. to 500 g/eq. The epoxy equivalent may be measured by the method in accordance with JIS K7236, as described above.

The weight-average molecular weight (Mw) of the epoxy resin is preferably 100 to 5,000, more preferably 250 to 3,000, and still more preferably 400 to 1,500. The Mw of the epoxy resin may be measured by the GPC method in terms of a polystyrene.

The radically polymerizable resin is not particularly restricted as long as it has one or more (preferably two or more) of the radically polymerizable unsaturated group per one molecule. Illustrative examples of the radically polymerizable resin may include resins having one or more of the radically polymerizable unsaturated group selected from a maleimide group, a vinyl group, an allyl group, a styryl group, a vinyl phenyl group, an acryloyl group, a methacryloyl group, a fumaroyl group, and a maleoyl group. In particular, from the viewpoint of being able to achieve the cured product exhibiting the favorable toughnesses in combination with the polyhydric phenol resin (X), it is preferable that the cross-linkable resin include one or more of the resin selected from a maleimide resin, a (meth)acrylic resin, and a styryl resin.

The maleimide resin is not particularly restricted as long as it has one or more (preferably two or more) maleimide groups (2,5-dihydro-2,5-dioxo-1H-pyrrole-1-yl group) per one molecule. Illustrative examples of the maleimide resin may include: maleimide resins including an aliphatic skeleton having 36 carbon atoms derived from a dimer diamine, such as "BMI-3000J", "BMI-5000", "BMI-1400", "BMI-1500", "BMI-1700", and "BMI-689" (all are manufactured by Designer Molecules Inc.); maleimide resins including an indane skeleton described in Disclosure No. 2020-500211 in Journal of Technical Disclosure of the Japan Institute of Invention and Innovation; and maleimide resins including an aromatic ring skeleton bonded directly to the nitrogen atom of the maleimide group, such as "MIR-3000-70MT" (manufactured by Nippon Kayaku Co., Ltd.), "BMI-4000" (manufactured by Daiwa Fine Chemicals Co., Ltd.), and "BMI-80" (manufactured by K-I Chemical Industry Co., Ltd.).

The (meth)acrylic resin is not particularly restricted as long as it has one or more (preferably two or more) (meth)acryloyl groups per one molecule, in which it may be a monomer or an oligomer. The term "(meth)acryloyl group" is a generic term for an acryloyl group and a methacryloyl group. Illustrative examples of the methacrylic resin may include, besides a (meth)acrylate monomer, (meth)acrylic resins such as "A-DOG" (manufactured by Shin-Nakamura Chemical Co., Ltd.), "DCP-A" (manufactured by Kyoeisha Chemical Co., Ltd.), and "NPDGA", "FM-400", "R-687", "THE-330", "PET-30", and "DPHA" (all being manufactured by Nippon Kayaku Co., Ltd.).

The styryl resin is not particularly restricted as long as it has one or more (preferably two or more) styryl groups or vinyl phenyl groups per one molecule, in which it may also be a monomer or an oligomer. Illustrative examples of the styryl resin may include, besides a styrene monomer, styryl resins such as "OPE-2St", "OPE-2St 1200", and "OPE-2St 2200" (all being manufactured by Mitsubishi Gas Chemical Co., Ltd.).

The resin composition of the present invention may include, as the cross-linkable resin (Y), only the thermosetting resin, only the radically polymerizable resin, or a combination of the thermosetting resin and the radically polymerizable resin. In one embodiment, the resin composition of the present invention includes the thermosetting resin in addition to the polyhydric phenol resin (X).

In the case that the resin composition of the present invention includes the cross-linkable resin (Y), from the viewpoint of achieving the cured product that exhibits the favorable toughnesses in combination with the polyhydric phenol resin (X), the content of the cross-linkable resin (Y) in the resin composition, when the amount of the resin components in the resin composition is defined as 100% by mass, is preferably 5% by mass or more, more preferably 10% by mass or more, and still more preferably 12% by mass or more, 14% by mass or more, or 150 by mass or more. The upper limit of the content is not particularly limited, and it may be determined in accordance with the properties required for the resin composition. It may be made, for example, 80% by mass or less, 70% by mass or less, 60% by mass or less, or 50% by mass or less.

In the resin composition of the present invention, from the viewpoint of achieving the advantageous effects of the present invention furthermore, the mass ratio of the polyhydric phenol resin (X) and the cross-linkable resin (Y) ((Y)/(X)) is preferably 4 or less, more preferably 3 or less, 2 or less, 1.5 or less, or 1 or less, and still more preferably 0.9 or less, 0.8 or less, 0.7 or less, 0.6 or less, or 0.5 or less. The lower limit of the mass ratio ((Y)/(X)) may be 0, and it may also be 0.01 or more, 0.05 or more, 0.1 or more, or the like. Accordingly, in one embodiment, the mass ratio of the polyhydric phenol resin (X) and the cross-linkable resin (Y) ((Y)/(X)) is in the range of 0 to 4.

### -Inorganic filler-

The resin composition of the present invention may further include an inorganic filler. By including the inorganic filler, it is possible to decrease a linear thermal expansion coefficient and a dielectric loss tangent.

Illustrative examples of the inorganic filler may include silica, alumina, barium sulfate, talc, clay, mica powder, aluminum hydroxide, magnesium hydroxide, calcium carbonate, magnesium carbonate, magnesium oxide, boron nitride, aluminum borate, barium titanate, strontium titanate, calcium titanate, magnesium titanate, bismuth titanate, titanium dioxide, barium zirconate, and calcium zirconate. Among these, silica is preferable. Illustrative examples of the silica may include amorphous silica, fused silica, crystalline silica, synthetic silica, and hollow silica. It is preferable that the silica is spherical. The inorganic filler may be used singly or as a combination of two or more of those described above. Illustrative examples of the commercially available inorganic filler may include "UFP-30" (manufactured by Denka Co., Ltd.); "YC100C", "YA050C", "YA050C-MJE", "YA010C", "SC2500SQ", "SO-C4", "SO-C2", "SO-C1", and "SC-C2" (all being manufactured by Admatechs Co., Ltd.); and "Silfil NSS-3N", "Silfil NSS-4N", and "Silfil NSS-5N" (all being manufactured by Tokuyama Corp.

The average particle diameter of the inorganic filler is preferably 5 µm or less, more preferably 2 µm or less, and further preferably 1 µm or less from the viewpoint of making the surface of the cured product (insulating layer) low roughness and facilitating fine wiring formation. The lower limit of the average particle diameter is not particularly limited, and may be, for example, 0.01 µm or more, 0.02 µm or more, or 0.03 µm or more. The average particle diameter of the inorganic filler may be measured by a laser diffraction scattering method based on the Mie scattering theory. Specifically, the average particle diameter may be measured by creating a particle size distribution of the inorganic filler on a volume basis by a laser diffraction scattering particle size distribution measuring apparatus, and using the obtained median diameter as the average particle diameter. As the measurement sample, an inorganic filler dispersed in water by ultrasonic waves may be preferably used. The laser diffraction scattering particle size distribution measuring apparatus to be used may include LA-950 manufactured by Horiba, Ltd. or the like.

The inorganic filler is preferably one obtained by performing a surface treatment with a surfaced treating agent, such as an aminosilane-based coupling agent, a ureidosilane-based coupling agent, an epoxy-silane-based coupling agent, a mercaptosilane-based coupling agent, a vinylsilane-based coupling agent, a styrylsilane-based coupling agent, an acrylate-silane-based coupling agent, an isocyanate-silane-based coupling agent, a sulfide silane-based coupling agent, an organosilazane compound, or a titanate-based coupling agent, to improve its moisture resistance and dispersibility.

When the resin composition of the present invention includes an inorganic filler, the content of the inorganic filler in the resin composition may be determined according to the properties required for the resin composition. When the nonvolatile component in the resin composition is defined as 100% by mass, for example, the content thereof is 5% by mass or more, 10% by mass or more, preferably 30% by mass or more, more preferably 40% by mass or more, and further preferably 50% by mass or more. The upper limit of the content of the inorganic filler is not particularly limited, and may be, for example, 90% by mass or less, and 80% by mass or less.

### -Resin crosslinking agent-

The resin composition of the present invention may further include a resin crosslinking agent (resin curing agent).

Illustrative examples of the resin crosslinking agent may include: active ester type crosslinking agents such as "EXB9451", "EXB9460", "EXB9460S", "HPC-8000-65T", "HPC-8000H-65TM", "EXB-8000L-65TM", "EXB-8500-65T", "EXB9416-70BK", "EXB-8100L-65T", "EXB-8150L-65T", "EXB-8150-65T", "HPC-8150-60T", "HPC-8150-62T", "HPB-8151-62T" (all being manufactured by DIC Corp.), "PC1300-02-65T" (manufactured by Air Water Inc.), "DC808", "YLH1026", "DC808", "YLH1026", "YLH1030", and "YLH1048" (all being manufactured by Mitsubishi Chemical Corp.); phenol type curing agents such as "TD2090", "TD2131" (these being manufactured by DIC Corp.), "MEH-7600", "MEH-7851", "MEH-8000H" (these being manufactured by Meiwa Plastic Industries, Ltd), "NHN", "CBN", "GPH-65", "GPH-103" (these being manufactured by Nippon Kayaku Co., Ltd.), "SN170", "SN180", "SN190", "SN475", "SN485", "SN495", "SN375", "SN395" (all being manufactured by Nippon Steel & Chemical Material Co., Ltd.), "LA7052", "LA7054", "LA3018", and "LA1356" (all being manufactured by DIC Corp.); benzoxazine type crosslinking agents such as "F-a", "P-d" (these being manufactured by Shikoku Chemical Corp.), and "HFB2006M" (manufactured by Showa Highpolymer Co., Ltd.); acid anhydride type crosslinking agents such as methylhexahydrophthalic anhydride, methylnadic anhydride, and hydrogenated methylnadic anhydride; cyanate ester type crosslinking agents such as "PT30", "PT60", and "BA230S75" (all being manufactured by Lonza Japan Ltd.); and benzoxazine type crosslinking agents.

When the resin composition of the present invention includes the resin crosslinking agent, the content of the resin crosslinking agent in the resin composition may be determined in accordance with the properties required for the resin composition. When the resin components in the resin composition is defined as 100% by mass, the content of the resin crosslinking agent is preferably 40% by mass or less, more preferably 20% by mass or less, and still more preferably 10% by mass or less, and the lower limit thereof may be 0.01% by mass or more, 0.05% by mass or more, 0.1% by mass or more, or the like.

### -Crosslinking accelerator-

The resin composition of the present invention may further include a crosslinking accelerator (curing accelerator). By including the crosslinking accelerator, the crosslinking time and temperature may be efficiently controlled.

Illustrative examples of the crosslinking accelerator may include organic phosphine compounds such as "TPP", "TPP-K", "TPP-S", and "TPTP-S" (all being manufactured by Hokko Chemical Industry Co., Ltd.); imidazole compounds such as "Curezol 2MZ", "2E4MZ", "Cl1Z", "Cl1Z-CN", "Cl1Z-CNS", "Cl1Z-A", "2MZ-OK", "2MA-OK", and "2PHZ" (all being manufactured by Shikoku Chemical Industry Co., Ltd.); amine adduct compounds such as "Novacure" (manufactured by Asahi Kasei Chemicals Co., Ltd.) and "Fujicure" (manufactured by Fuji Kasei Co., Ltd.); amine compounds such as 1,8-diazabicyclo[5,4,0]undecene-7,4-dimethylaminopyridine, benzyldimethylamine, 2,4,6-tris(dimethylaminomethyl)phenol, and 4-dimethylaminopyridine; and organometallic complexes or organometallic salts of cobalt, copper, zinc, iron, nickel, manganese, tin, and the like.

When the resin composition of the present invention includes the crosslinking accelerator, the content of the crosslinking accelerator in the resin composition may be determined in accordance with the properties required for the resin composition. When the amount of the resin components in the resin composition is defined as 100% by mass, the content of the crosslinking accelerator is preferably 5% by mass or less, more preferably 4% by mass or less, still more preferably 3% by mass or less, and the lower limit thereof may be 0.01% by mass or more, 0.05% by mass or more, 0.1% by mass or more, or the like.

### -Other additives-

The resin composition of the present invention may further include other additives. Illustrative examples of such additive may include: organic fillers such as a rubber particle; photo cationic polymerization initiators and photoacid generators such as a sulfonium salt type, an iodonium salt type, and a nonionic type photo cationic polymerization initiator and photoacid generator; photosensitive agents such as a naphthoquinone diazide compound; radical polymerization initiators such as a peroxide type radical polymerization initiator and an azo type radical polymerization initiator; thermoplastic resins such as a phenoxy resin, a polyvinyl acetal resin, a polysulfone resin, a polyether sulfone resin, a polyphenylene ether resin, a polyether ether ketone resin, and a polyester resin; organic metal compounds such as an organic copper compound, an organic zinc compound, and an organic cobalt compound; coloring agents such as a phthalocyanine blue, a phthalocyanine green, an iodine green, a diazo yellow, a crystal violet, titanium dioxide, and carbon black; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; fluorescent brighteners such as a stilbene derivative; surfactants such as a fluorine type surfactant and a silicone type surfactant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); dispersants such as a phosphate ester type dispersant, a polyoxyalkylene type dispersant, an acetylene type dispersant, a silicone type dispersant, an anionic dispersant, and a cationic dispersant; and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. The content of such additives may be determined in accordance with the properties required for the resin composition.

The resin composition of the present invention may further include an organic solvent as a volatile component. Illustrative examples of the organic solvent may include: a ketone-based solvent such as acetone, methyl ethyl ketone, methyl isobutyl ketone, and cyclohexanone; an ester-based solvent such as methyl acetate, ethyl acetate, butyl acetate, isobutyl acetate, isoamyl acetate, methyl propionate, ethyl propionate, and γ-butyrolactone; an ether-based solvent such as tetrahydropyran, tetrahydrofuran, 1,4-dioxane, diethyl ether, diisopropyl ether, dibutyl ether, and diphenyl ether; an alcohol-based solvent such as methanol, ethanol, propanol, butanol, and ethylene glycol; an ether ester-based solvent such as 2-ethoxyethyl acetate, propylene glycol monomethyl ether acetate, diethylene glycol monoethyl ether acetate, ethyl diglycol acetate, γ-butyrolactone, and methyl methoxypropionate; an ester alcohol-based solvent such as methyl lactate, ethyl lactate, and methyl 2-hydroxyisobutyrate; an ether alcohol-based solvent such as 2-methoxypropanol, 2-methoxyethanol, 2-ethoxyethanol, propylene glycol monomethyl ether, and diethylene glycol monobutyl ether (butyl carbitol); an amide-based solvent such as N,N-dimethylformamide, N,N-dimethylacetamide, and N-methyl-2-pyrrolidone; a sulfoxide-based solvent such as dimethyl sulfoxide; a nitrile-based solvent such as acetonitrile and propionitrile; an aliphatic hydrocarbon-based solvent such as hexane, cyclopentane, cyclohexane, and methylcyclohexane; and an aromatic hydrocarbon-based solvent such as benzene, toluene, xylene, ethylbenzene, and trimethylbenzene. The organic solvent may be used singly or in a combination of two or more of those described above.

When the resin composition of the present invention includes the organic solvent, the content of the organic solvent in the resin composition may be determined in accordance with the properties required for the resin composition. When the amount of all the components in the resin composition is defined as 100% by mass, the content of the organic solvent may be made, for example, 60% by mass or less, 40% by mass or less, 30% by mass or less, 20% by mass or less, 15% by mass or less, or 10% by mass or less.

The resin composition of the present invention may be prepared by appropriately mixing the necessary components among the above-mentioned components, and kneading or mixing by a kneading means such as a three-roll roll, a ball mill, a bead mill, a sand mill, or the like, or a stirring means such as a super mixer, a planetary mixer, or the like as necessary.

The resin composition of the present invention may be prepared as a thermosetting resin composition or as a photo-curable resin composition by using, in addition to the polyhydric phenol resin (X), those components described above in an appropriate combination. For example, the thermosetting resin composition may be prepared by using, in addition to the polyhydric phenol resin (X), one or more of the component selected from the group consisting of the cross-linkable resin (Y), the inorganic filler, the resin crosslinking agent, the crosslinking accelerator, and the aforementioned other additives. In addition, a combination of the polyhydric phenol resin (X) with one or more of the substance selected from the group consisting of the photo cationic polymerization initiator, the photoacid generator, and the photosensitive agent, as well as one or more of the substance selected from the group consisting of the cross-linkable resin (Y), the inorganic filler, the resin crosslinking agent, the crosslinking accelerator, and the aforementioned other additives, may be used to prepare the photo-curable resin composition. Accordingly, in one embodiment, the resin composition of the present invention is the thermosetting resin composition or the photo-curable resin composition.

The resin composition of the present invention, which includes the polyhydric phenol resin (X), may achieve the cured product exhibiting the favorable toughnesses.

In one embodiment, the cured product of the resin composition of the present invention has characteristics of exhibiting a high flexural toughness. For example, when measured in accordance with JIS K7171 to be described in the section of [Flexural Toughness] later, the flexural toughness of the cured product of the resin composition of the present invention may become preferably 4.5 MPa or more, 5.0 MPa or more, 5.2 MPa or more, 5.4 MPa or more, or 5.5 MPa or more.

In one embodiment, the cured product of the resin composition of the present invention has a characteristic of exhibiting a high tensile toughness. For example, when measured in accordance with JIS K7161 as described in the section of [Tensile Toughness] later, the tensile toughness of the cured product of the resin composition of the present invention may become preferably 1.0 MPa or more, 1.2 MPa or more, 1.4 MPa or more, 1.5 MPa or more or, or 1.6 MPa or more.

As described before, the resin composition of the present invention may achieve the cured product exhibiting favorable toughnesses. Accordingly, the resin composition of the present invention may be suitably used as the resin composition for forming an automotive part such as a brake (resin composition for an automotive part). The resin composition of the present invention may also be suitably used as the resin composition for forming an insulating layer of a printed wiring board (resin composition for an insulating layer of printed wiring board), because it is able to achieve the cured product that exhibits the favorable toughnesses and also suppress a cracking defect even when the thickness of the cured product is reduced. This may be used more preferably as the resin composition for forming an interlayer insulating layer of a printed wiring board (resin composition for an interlayer insulating layer of a printed wiring board). The resin composition of the present invention can also be suitably used in a case where the printed wiring board is a component-embedded circuit board. The resin composition of the present invention may also be suitably used as the resin composition for sealing a semiconductor chip (resin composition for sealing a semiconductor). The resin composition of the present invention can be suitably used as a resin composition for the redistribution forming layer as an insulation layer for forming the redistribution layer (resin composition for a redistribution forming layer). The resin composition of the present invention can also be used in a wide range of applications where a resin composition is required, such as a sheet-like laminated material such as a resin sheet or a prepreg, a solder resist, an underfill material, a die bonding material, a hole-filling resin, and a component-embedding resin.

### [Sheet-like laminated Material (resin sheet and prepreg)]

The resin composition of the present invention may be used as it is or in the form of a sheet-like laminated material including the resin composition.

As the sheet-like laminated material, the resin sheet and prepreg described below are preferable.

In one embodiment, the resin sheet includes a support and a layer of the resin composition formed on the support (hereinafter simply referred to as "resin composition layer"), in which the resin composition layer is formed of the resin composition of the present invention.

The thickness of the resin composition layer varies in preferable values depending on applications and may be appropriately determined according to the applications. For example, the thickness of the resin composition layer is preferably 200 µm or less, more preferably 150 µm or less, 120 µm or less, 100 µm or less, 80 µm or less, 60 µm or less, or 50 µm or less, from the viewpoint of reducing the thickness of the printed wiring board or the semiconductor chip package. Although the lower limit of the thickness of the resin composition layer is not particularly limited, it may be usually 1 µm or more, 5 µm or more, or the like.

Illustrative examples of the support may include a thermoplastic resin film, metal foil, and a release paper. Among these, a thermoplastic resin film and metal foil are preferable. Accordingly, in one preferable embodiment, the support is a thermoplastic resin film or metal foil.

In a case where a thermoplastic resin film is used as the support, illustrative examples of the thermoplastic resin may include: polyesters such as polyethylene terephthalate (PET) and polyethylene naphthalate (PEN); polycarbonate (PC); acryls such as polymethyl methacrylate (PMMA); a cyclic polyolefin; triacetyl cellulose (TAC); polyether sulfide (PES); polyether ketone; and polyimide. Among these, polyethylene terephthalate and polyethylene naphthalate are preferable, and an inexpensive polyethylene terephthalate is especially preferable.

In a case where a metal foil is used as the support, illustrative examples of the metal foil may include a copper foil and an aluminum foil. Of these, the copper foil is preferable. As the copper foil, a foil made of a single metal of copper may be used, or a foil made of an alloy of copper and different metal (e.g., tin, chromium, silver, magnesium, nickel, zirconium, silicon, titanium, etc.) may be used.

The support may be subjected to a matte treatment, a corona treatment, and an antistatic treatment on the surface to be bonded to the resin composition layer. Furthermore, as the support, a support with release layer having a release layer on the surface to be bonded to the resin composition layer may be used. A release agent used in the release layer of the support with release layer may be one or more release agents selected from the group consisting of an alkyd resin, a polyolefin resin, a urethane resin, and a silicone resin. A commercially available product may be used as the support with release layer. Examples thereof may include "SK-1", "AL-5", and "AL-7" manufactured by Lintec Corp., which are a PET film with a release layer including an alkyd resin-based release agent as a main component, "LUMIRROR T60" manufactured by Toray Industries, Inc., "PUREX" manufactured by Teijin Ltd., and "UNIPEEL" manufactured by Unitika Ltd.

The thickness of the support is not particularly limited. However, the thickness is preferably in a range of 5 µm to 75 µm, more preferably in a range of 10 µm to 60 µm. Note that, in a case where the support with release layer is used, the thickness of the support with release layer as a whole is preferably within the above-mentioned range.

In a case where a metal foil is used as the support, a metal foil with supporting substrate, in which a peelable supporting substrate is bonded to a thin metal foil, may also be used. In an embodiment, the metal foil with supporting substrate includes a supporting substrate, a release layer disposed on the supporting substrate, and a metal foil disposed on the releasing layer. In a case where the metal foil with supporting substrate is used as the support, the resin composition layer is disposed on the metal foil.

In the metal foil with supporting substrate, a material of the supporting substrate is not particularly limited. However, examples of the material may include a copper foil, an aluminum foil, a stainless-steel foil, a titanium foil, and a copper alloy foil. In a case where a copper foil is used as the supporting substrate, an electrolytic copper foil or a rolled copper foil may be used. Furthermore, the release layer is not particularly limited as long as the metal foil can be released from the supporting substrate. Examples of the release layer may include: an alloy layer of elements selected from the group consisting of Cr, Ni, Co, Fe, Mo, Ti, W, and P; and an organic film.

In the metal foil with supporting substrate, preferable examples of a material of the metal foil may include a copper foil and a copper alloy foil.

In the metal foil with supporting substrate, the thickness of the supporting substrate is not particularly limited. However, the thickness is preferably in the range of 10 µm to 150 µm, and more preferably in the range of 10 µm to 100 µm. The thickness of the metal foil may be in the range of 0.1 µm to 10 µm, for example.

In an embodiment, the resin sheet may further include an optional layer as necessary. Examples of such an optional layer may include a protective film disposed on the surface of the resin composition layer, which is not bonded to the support (i.e., the surface on the opposite side to the support). The thickness of the protective film is not particularly limited. However, the thickness is, for example, 1 µm to 40 µm. Laminating the protective film can prevent the surface of the resin composition layer from being dusted or scratched.

The resin sheet can be produced by, for example, using the liquid resin composition as it is or preparing a resin varnish by dissolving the resin composition in an organic solvent, applying such a resin composition onto the support using a die coater or the like, and then drying the resin composition to form a resin composition layer.

Examples of the organic solvent may include the same organic solvents described as the component of the resin composition. As the organic solvent, one type thereof may be solely used, and two or more types thereof may also be used in combination.

The drying may be performed by a known method such as heating or blowing with hot air. Although a drying condition is not particularly limited, the drying is performed so that the content of the organic solvent in the resin composition layer is reduced to 10% by mass or less, preferably 5% by mass or less. The drying condition varies depending on the boiling point of the organic solvent in the resin composition or the resin varnish. For example, in a case where the resin composition or the resin varnish including 30% by mass to 60% by mass of the organic solvent is used, the resin composition layer can be formed by drying the resin composition or the resin varnish at 50°C to 150°C for 3 minutes to 10 minutes.

The resin sheet can be wound into a roll and stored. In a case where the resin sheet has a protective film, the resin sheet can be used by peeling off the protective film.

In an embodiment, the prepreg is formed by impregnating a sheet-like fiber substrate with the resin composition of the present invention.

The sheet-like fiber substrate used for the prepreg is not particularly limited. A material commonly used as a substrate for prepreg, such as glass cloth, aramid nonwoven fabric, or liquid crystal polymer nonwoven fabric, can be used. From the viewpoint of reducing the thickness of the printed wiring board or the semiconductor chip package, the thickness of the sheet-like fiber substrate is preferably 50 µm or less, more preferably 40 µm or less, further preferably 30 µm or less, and particularly preferably 20 µm or less. The lower limit of the thickness of the sheet-like fiber substrate is not particularly limited. However, it is usually 10 µm or more.

The prepreg can be produced by a known method such as a hot melt method and a solvent method.

The thickness of the prepreg can be in the same range as the resin composition layer in the resin sheet described above.

The sheet-like laminated material of the present invention can be suitably used for forming an insulation layer of the printed wiring board (for an insulation layer of printed wiring board), and more suitably used for forming an interlayer insulation layer of the printed wiring board (for an interlayer insulation layer of printed wiring board). The sheet-like laminated material of the present invention can also be suitably used for sealing the semiconductor chip (for sealing semiconductor). The sheet-like laminated material of the present invention can be suitably used for a redistribution forming layer as an insulation layer for forming the redistribution layer.

### [Printed wiring board]

The printed wiring board of the present invention includes the insulation layer formed of the cured product of the resin composition of the present invention.

The printed wiring board can be produced by, for example, a method including the following steps (I) and (II) using the above-mentioned resin sheet:
(I) a step of laminating a resin sheet on an inner layer substrate so that a resin composition layer of the resin sheet is bonded to the inner layer substrate; and
(II) a step of curing (e.g., thermally curing) the resin composition layer to form an insulation layer.

The "inner layer substrate" used in the step (I) is a member that serves as a substrate of the printed wiring board. Examples of the inner layer substrate may include a glass epoxy substrate, a metal substrate, a polyester substrate, a polyimide substrate, a BT resin substrate, and a thermosetting polyphenylene ether substrate. Furthermore, such a substrate may have a conductor layer on one or both surfaces, and this conductor layer may be patterned. The inner layer substrate having the conductor layer (circuit) formed on one or both surfaces of the substrate is sometimes referred to as an "inner layer circuit substrate". Furthermore, an intermediate product on which the insulation layer and/or the conductive layer are to be formed in the production of the printed wiring board is also included in the "inner layer substrate" as defined in the present invention. In a case where the printed wiring board is a component-embedded circuit board, an inner layer substrate having components embedded may be used.

The lamination of the inner layer substrate and the resin sheet can be performed by, for example, thermocompression bonding of the resin sheet to the inner layer substrate carried out from the support side. Examples of a member for use in performing the thermocompression bonding of the resin sheet to the inner layer substrate (hereinafter also referred to as "thermocompression bonding member") may include a heated metal plate (a SUS head plate, etc.) and a heated metal roll (a SUS roll). Note that the thermocompression bonding member may be directly pressed onto the resin sheet or may be pressed through an elastic material such as heat-resistant rubber so that the resin sheet sufficiently follows the uneven surface of the inner layer substrate.

The lamination of the inner layer substrate and the resin sheet may be performed by a vacuum lamination method. In the vacuum lamination method, the thermocompression bonding temperature is preferably in a range of 60°C to 160°C, more preferably 80°C to 140°C, the thermocompression bonding pressure is preferably in a range of 0.098 MPa to 1.77 MPa, more preferably 0.29 MPa to 1.47 MPa, and the thermocompression bonding time is preferably in a range of 20 seconds to 400 seconds, more preferably 30 seconds to 300 seconds. The lamination can be performed under a reduced pressure condition, preferably at a pressure of 26.7 hPa or less.

The lamination can be performed with a commercially available vacuum laminator. Examples of the commercially available vacuum laminator may include a vacuum pressure laminator manufactured by Meiki Co., Ltd., and a vacuum applicator and a batch type vacuum pressure laminator manufactured by Nikko-Materials Co., Ltd.

After the lamination, the laminated resin sheet may be subjected to a smoothing treatment by, for example, pressing the laminated resin sheet from the support side with the thermocompression member under normal pressure (atmospheric pressure). A pressing condition for the smoothing treatment can be the same as the condition for the thermocompression bonding used for the lamination described above. The smoothing treatment can be performed with a commercially available laminator. Note that the lamination and the smoothing treatment may be performed successively using the commercially available vacuum laminator described above.

The support may be removed between the step (I) and the step (II) or may be removed after the step (II). Note that, in a case where a metal foil is used as the support, the conductive layer may be formed using the metal foil without peeling off the support. Furthermore, in a case where a metal foil with supporting substrate is used as the support, the supporting substrate (and the release layer) is simply peeled off. Then, a conductive layer can be formed using the metal foil.

In the step (II), the resin composition layer is cured (e.g., thermally cured) to form an insulation layer formed of a cured product of the resin composition. A curing condition for the resin composition layer is not particularly limited, and the condition usually employed for forming an insulation layer of the printed wiring board may be used.

The thermal curing condition for the resin composition layer varies depending on the type of the resin composition and the like. However, for example, in an embodiment, the curing temperature is preferably 120°C to 250°C, more preferably 150°C to 240°C, and further preferably 180°C to 230°C. The curing time can be preferably 5 minutes to 240 minutes, more preferably 10 minutes to 150 minutes, and further preferably 15 minutes to 120 minutes.

Before being thermally cured, the resin composition layer may be preheated at a temperature lower than the curing temperature. For example, before being thermally cured, the resin composition layer may be preheated at a temperature of 50°C to 120°C, preferably 60°C to 115°C, more preferably 70°C to 110°C for 5 minutes or more, preferably 5 minutes to 150 minutes, more preferably 15 minutes to 120 minutes, and further preferably 15 minutes to 100 minutes.

In the production of the printed wiring board, a step (III) of perforating the insulation layer, a step (IV) of subjecting the insulation layer to a roughening treatment, and a step (V) of forming a conductive layer may be further performed. These steps (III) to (V) may be performed according to various methods known to those skilled in the art used in the production of the printed wiring board. Note that, in a case where a support is removed after the step (II), the support may be removed between the step (II) and the step (III), between the step (III) and the step (IV), or between the step (IV) and the step (V). Furthermore, if necessary, the steps (I) to (V) of forming the insulation layer and the conductive layer may be repeated to form a multilayer wiring board.

In another embodiment, the printed wiring board of the present invention can be produced using the prepreg described above. A production method is basically the same as the method using the resin sheet.

The step (III) is a step of perforating the insulation layer, whereby a hole such as a via hole or a through hole can be formed in the insulation layer. The step (III) may be performed using, for example, a drill, laser, plasma, or the like, depending on the composition and the like of the resin composition used for forming the insulation layer. The dimension and shape of the hole may be appropriately determined according to a design of the printed wiring board.

The step (IV) is a step of subjecting the insulation layer to a roughening treatment. Usually, removal of smear (desmear) is also performed in this step (IV). A procedure and condition for the roughening treatment are not particularly limited, and a known procedure and condition that are commonly used for forming an insulation layer of the printed wiring board can be employed. For example, the roughening treatment of the insulation layer can be performed by carrying out a swelling treatment with a swelling liquid, a roughening treatment with an oxidizing agent, and a neutralizing treatment with a neutralizing liquid, in this order.

The swelling liquid used for the roughening treatment is not particularly limited. However, examples thereof may include an alkaline solution and a surfactant solution. Of these, an alkaline solution is preferable. As the alkaline solution, a sodium hydroxide solution and a potassium hydroxide solution are more preferable. Examples of a commercially available swelling liquid may include "SWELLING DIP SECURIGANTH P" and "SWELLING DIP SECURIGANTH SBU" manufactured by Atotech Japan K.K. The swelling treatment with the swelling liquid is not particularly limited. However, the swelling treatment can be performed by, for example, immersing the insulation layer in the swelling liquid at 30°C to 90°C for 1 minute to 20 minutes. From the viewpoint of restraining swelling of the resin in the insulation layer to an appropriate level, it is preferable to immerse the insulation layer in the swelling liquid at 40°C to 80°C for 5 minutes to 15 minutes.

The oxidizing agent used in the roughening treatment is not particularly limited. However, examples of the oxidizing agent may include an alkaline permanganate solution in which potassium permanganate or sodium permanganate is dissolved in an aqueous solution of sodium hydroxide. The roughening treatment with the oxidizing agent such as the alkaline permanganate solution is preferably performed by immersing the insulation layer in the oxidizing agent solution heated to 60°C to 100°C for 10 minutes to 30 minutes. Furthermore, a concentration of the permanganate in the alkaline permanganate solution is preferably 5% by mass to 10% by mass. Examples of a commercially available oxidizing agent may include an alkaline permanganate solution such as "CONCENTRATE COMPACT CP" or "DOSING SOLUTION SECURIGANS P" manufactured by Atotech.

Furthermore, the neutralizing liquid used for the roughening treatment is preferably an acidic aqueous solution. Examples of a commercially available neutralizing liquid may include "REDUCTION SOLUTION SECURIGANTH P" manufactured by Atotech.

The treatment with the neutralizing liquid can be performed by immersing the treated surface, which has been subjected to the roughening treatment with the oxidizing agent, in the neutralizing liquid at 30°C to 80°C for 5 minutes to 30 minutes. From the viewpoint of workability and the like, a method of immersing the object, which has been subjected to the roughening treatment with the oxidizing agent, in the neutralizing liquid at 40°C to 70°C for 5 minutes to 20 minutes is preferable.

The step (V) is a step of forming a conductive layer, whereby the conductive layer is formed on the insulation layer. A conductor material used for the conductive layer is not particularly limited. In a preferred embodiment, the conductive layer includes one or more types of metal selected from the group consisting of gold, platinum, palladium, silver, copper, aluminum, cobalt, chromium, zinc, nickel, titanium, tungsten, iron, tin, and indium. The conductive layer may be a single metal layer or an alloy layer. Examples of the alloy layer may include a layer formed of an alloy of two or more different metal selected from the above-mentioned group (e.g., a nickel-chromium alloy, a copper-nickel alloy, and a copper-titanium alloy). Of these, from the viewpoint of versatility and costs for forming the conductive layer, easiness of patterning, and the like, a single metal layer of chromium, nickel, titanium, aluminum, zinc, gold, palladium, silver, or copper, or an alloy layer of a nickel-chromium alloy, a copper-nickel alloy, or a copper-titanium alloy is preferable. A single metal layer of chromium, nickel, titanium, aluminum, zinc, gold, palladium, silver, or copper, or an alloy layer of a nickel-chromium alloy is more preferable, and a single metal layer of copper is still more preferable.

The conductive layer may have a single layer structure or a multi-layer structure in which two or more single metal layers or alloy layers formed of different types of metal or alloys are laminated. In a case where the conductive layer has the multilayer structure, a layer in contact with the insulation layer is preferably a single metal layer of chromium, zinc, or titanium, or an alloy layer of a nickel-chromium alloy.

The thickness of the conductive layer is generally 3 µm to 35 µm, preferably 5 µm to 30 µm, depending on a desired design of the printed wiring board.

In an embodiment, the conductive layer may be formed by plating. For example, the conductive layer having a desired wiring pattern can be formed by plating the surface of the insulation layer by a conventionally known technique such as a semi-additive method or a full-additive method. From the viewpoint of simplicity in the production, the conductive layer is preferably formed by the semi-additive method. An example of forming the conductive layer by the semi-additive method will be described below.

First, a plating seed layer is formed on the surface of the insulation layer by electroless plating. Next, a mask pattern is formed on the plating seed layer thus formed to expose a part of the plating seed layer corresponding to a desired wiring pattern. After a metal layer is formed on the exposed plating seed layer by electroplating, the mask pattern is removed. Subsequently, the unnecessary plating seed layer is removed by etching or the like to form the conductive layer having a desired wiring pattern.

In another embodiment, the conductive layer may be formed using a metal foil. In a case where the metal foil is used to form the conductive layer, the step (V) is performed preferably between the step (I) and the step (II). For example, after the step (I), the support is removed, and then the metal foil is laminated on the exposed surface of the resin composition layer. Lamination of the resin composition layer and the metal foil may be performed by a vacuum lamination method. A lamination condition may be the same as the condition described for the step (I). Next, the step (II) is performed to form the insulation layer. Subsequently, the conductive layer having a desired wiring pattern can be formed using the metal foil on the insulation layer by a conventional known technique such as a subtractive method or a modified semi-additive method.

The metal foil can be produced by a known method such as, for example, an electrolysis method or a rolling method. Examples of a commercially available metal foil may include HLP foil and JXUT-III foil manufactured by JX Nippon Mining & Metals Corp. and 3EC-III foil and TP-III foil manufactured by Mitsui Mining & Smelting Co., Ltd.

Alternatively, as described above, in the case where the metal foil or the metal foil with supporting substrate is used as the support for the resin sheet, the conductive layer may be formed using the metal foil.

### [Semiconductor chip package]

The semiconductor chip package of the present invention includes a sealing layer formed of the cured product of the resin composition of the present invention. As described above, the semiconductor chip package of the present invention may also include an insulation layer for forming a redistribution layer (redistribution forming layer), which is formed of the cured product of the resin composition of the present invention.

The semiconductor chip package can be produced, for example, using the resin composition or the resin sheet of the present invention by a method including the following steps (1) to (6). The resin composition or the resin sheet of the present invention may be used to form a sealing layer in the step (3) or a redistribution forming layer in the step (5). An example of forming the sealing layer and the redistribution forming layer using the resin composition or the resin sheet will be described below. However, a technique for forming the sealing layer and the redistribution forming layer of the semiconductor chip packages is known, and those skilled in the art can produce the semiconductor package according to the known technique using the resin composition or the resin sheet of the present invention:
(1) a step of laminating a temporary fixing film on a substrate;
(2) a step of temporarily fixing a semiconductor chip on the temporary fixing film;
(3) a step of forming a sealing layer on the semiconductor chip;
(4) a step of peeling off the substrate and the temporary fixing film from the semiconductor chip;
(5) a step of forming a redistribution forming layer as an insulation layer on the surface of the semiconductor chip from which the substrate and the temporary fixing film have been peeled off; and
(6) a step of forming a redistribution layer as a conductive layer on the redistribution forming layer

### -Step (1)-

A material used for the substrate is not particularly limited. Examples of the substrate may include: a silicon wafer; a glass wafer; a glass substrate; a metal substrate such as copper, titanium, stainless steel, and steel plate cold commercial (SPCC); a substrate prepared by impregnating a glass fiber with an epoxy resin or the like, followed by a thermal curing treatment (e.g., FR-4 substrate); and a substrate made of a bismaleimide triazine resin (BT resin).

A material of the temporary fixing film is not particularly limited as long as the temporary fixing film can temporarily fix the semiconductor chip and can be peeled off from the semiconductor chip in the step (4). A commercially available product can be used as the temporary fixing film. Examples of the commercially available product thereof may include REVALPHA manufactured by Nitto Denko Corp.

### -Step (2)-

The temporal fixing of the semiconductor chip can be performed using a known device such as a flip chip bonder or a die bonder. Arrangement layout and the installation number of the semiconductor chips can be appropriately determined according to the shape and size of the temporary fixing film, the production number of the semiconductor packages of interest, and the like. For example, the semiconductor chips can be arranged in a matrix form of multiple rows and multiple columns and temporarily fixed.

### -Step (3)-

The resin composition layer of the resin sheet of the present invention is laminated on the semiconductor chip, or the resin composition of the present invention is applied onto the semiconductor chip and then cured (e.g., thermally cured), to form a sealing layer.

For example, the lamination of the semiconductor chip and the resin sheet can be performed by removing the protective film from the resin sheet and performing thermocompression bonding of the resin sheet to the semiconductor chip from the support side. Examples of a member for performing the thermocompression bonding of the resin sheet to the semiconductor chip (hereinafter also referred to as "thermocompression bonding member") may include a heated metal plate (a SUS head plate, etc.) and a heated metal roll (a SUS roll). Further, it is preferable that, instead of directly pressing the thermocompression member onto the resin sheet, the thermocompression member is pressed onto the resin sheet through an elastic material such as heat-resistant rubber so that the resin sheet sufficiently follows the uneven surface of the semiconductor chip. The lamination of the semiconductor chip and the resin sheet may be performed by a vacuum lamination method, and a condition for the lamination is the same as the lamination condition described in relation to the method for producing the printed wiring board. Preferable ranges thereof are also the same.

After the lamination, the resin composition is thermally cured to form a sealing layer. A thermal curing condition is the same as the thermal curing condition described in relation to the method for producing the printed wiring board.

The support of the resin sheet may be peeled off after the resin sheet is laminated onto the semiconductor chip and thermally cured, or the support may be peeled off before the resin sheet is laminated onto the semiconductor chip.

In a case where the resin composition of the present invention is applied to form a sealing layer, a condition for the application is the same as the application condition for forming the resin composition layer described in relation to the resin sheet of the present invention. Preferable ranges thereof are also the same.

### -Step (4)-

A method for peeling off the substrate and the temporary fixing film can be appropriately changed according to the material of the temporary fixing film and the like. Example of the method may include a method in which the temporary fixing film is peeled off by heating and foaming (or expanding) the temporary fixing film and a method in which the temporary fixing film is peeled off by irradiating the film with ultraviolet rays from the substrate side and thereby reducing the adhesive force of the temporary fixing film.

In the method in which the temporary fixing film is peeled off by heating and foaming (or expanding) the temporary fixing film, a heating condition is usually 100 to 250°C for 1 to 90 seconds or 5 to 15 minutes. Furthermore, in the method in which the temporary fixing film is peeled off by irradiating the film with ultraviolet rays from the substrate side and thereby reducing the adhesive force of the temporary fixing film, an irradiation dose of ultraviolet rays is usually 10 mJ/cm² to 1000 mJ/cm².

### -Step (5)-

A material for forming the redistribution forming layer (insulation layer) is not particularly limited as long as insulation properties are exhibited when the redistribution forming layer (insulation layer) is formed. From the viewpoint of easiness in the production of the semiconductor chip package, a UV-curable resin or a thermosetting resin is preferable. The redistribution forming layer may be formed using the resin composition or the resin sheet of the present invention.

After the redistribution forming layer is formed, a via hole may be formed in the redistribution forming layer for interlayer connection between the semiconductor chip and a conductive layer described below. The via hole may be formed by a known method depending on the material of the rewiring forming layer.

### -Step (6)-

The formation of the conductive layer on the redistribution forming layer may be performed in the same manner as the step (V) described in relation to the method for producing the printed wiring board. Note that the step (5) and the step (6) may be repeated to alternately laminate (build up) the conductive layers (redistribution layers) and the redistribution forming layers (insulation layers).

In the production of the semiconductor chip package, a step (7) of forming a solder resist layer on the conductive layer (redistribution layer), a step (8) of forming a bump, and a step (9) of dicing a plurality of semiconductor chip packages into individual semiconductor chip packages, thereby separating them as individual pieces, may be further performed. These steps may be performed according to various methods known to those skilled in the art used in the production of the semiconductor chip package.

When the sealing layer and the redistribution forming layer are formed by using the resin composition or the resin sheet of the present invention that achieves a cured product exhibiting favorable toughnesses, regardless of whether the semiconductor package is a fan-in type package or a fan-out type package, it is possible to achieve the semiconductor chip package. In an embodiment, the semiconductor chip package of the present invention is a fan-out type package. The resin composition or the resin sheet of the present invention can be applied for both fan-out panel level packaging (FOPLP) and fan-out wafer level packaging (FOWLP). In an embodiment, the semiconductor package of the present invention is a product of the fan-out panel level packaging (FOPLP). In another embodiment, the semiconductor package of the present invention is a product of the fan-out wafer level packaging (FOWLP).

### [Semiconductor device]

A semiconductor device of the present invention includes a layer formed of the cured product of the resin composition layer of the present invention. The semiconductor device of the present invention can be produced by using the printed wiring board or the semiconductor chip package of the present invention.

Examples of the semiconductor device may include various semiconductor devices used in electrical products (e.g., a computer, a mobile phone, a digital camera, a television, etc.) and vehicles (e.g., a motorcycle, an automobile, a train, a ship, an aircraft, etc.).

### Examples

Hereinafter, the present invention will be described specifically by means of Examples. The present invention is not limited to these Examples.

### <Example 1> Synthesis of polyhydric phenol resin (1)

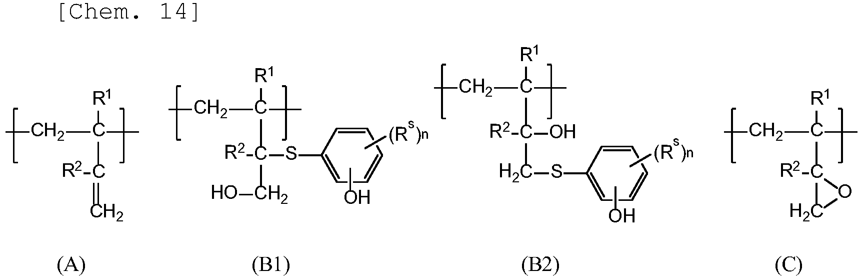

To a 200-mL flask equipped with a stirrer and a thermometer, 400 g of an epoxidized polybutadiene resin ("JP-100", manufactured by Nippon Soda Co., Ltd., epoxy equivalent of 200 g/eq.; in the aforementioned formula (x1), a=4 to 7 and a+c=16 to 25, R¹ and R² are a hydrogen atom)(2.0 mol of epoxy group) and 239 g (1.9 mol) of p-mercaptophenol (manufactured by Sankyo Chemical Co., Ltd.; in the aforementioned formula (x2), n=0) were added as the raw material with the existence ratio of the structural units described above being (A) : [(B1) + (B2)] : (C) = 71:28:1 (molar ratio) as the raw material ratio, and with both R¹ and R² in the formulas being a hydrogen atom and n=0. Then, the resulting mixture was heated to 90°C with stirring. The stirring at this temperature was continued for 10 hours to obtain 601 g of a pale yellow resin.

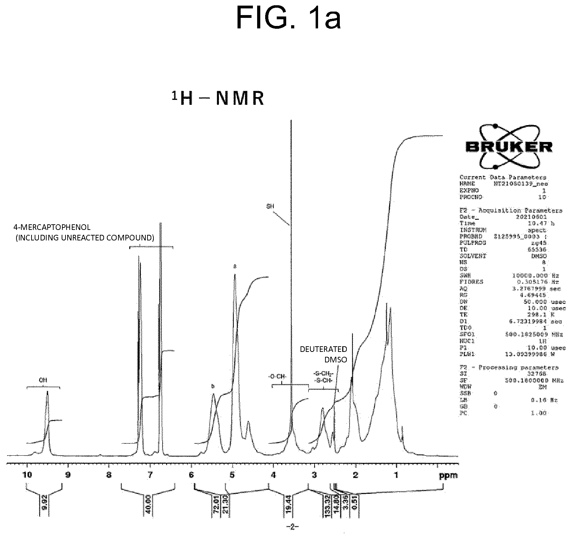

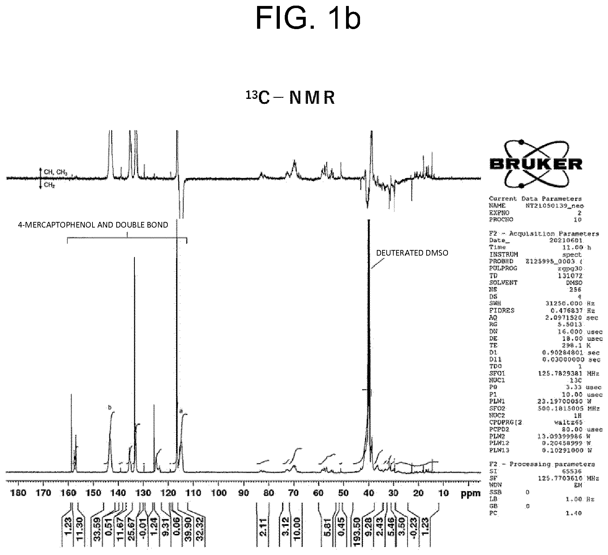

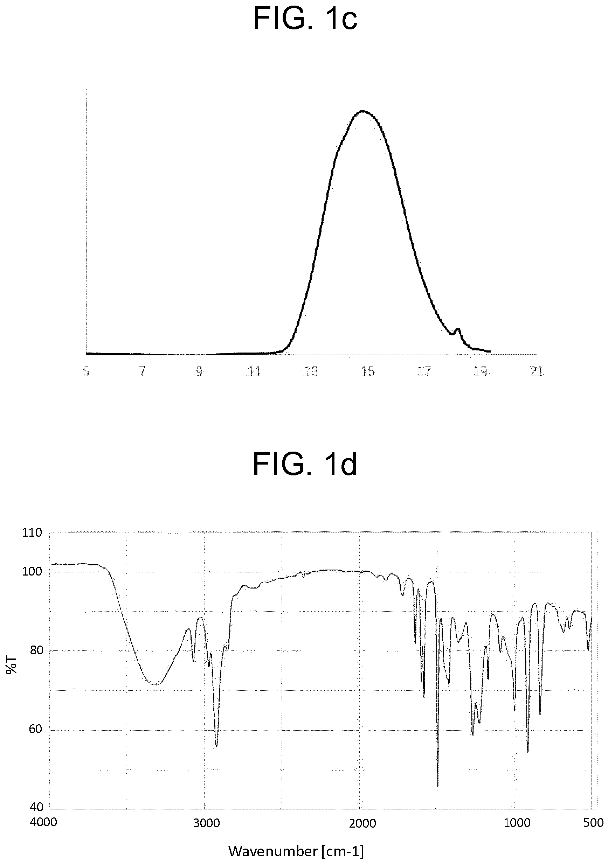

The ¹H-NMR spectrum, the ¹³C-NMR spectrum, the GPC chart, and the IR chart of the obtained resin, measured by the following methods, are described in FIG. 1a, FIG. 1b, FIG. 1c, and FIG. 1d, respectively. From these results, it was confirmed that the obtained resin had the intended molecular structure. According to the following measurement method with regard to the resin obtained, the hydroxy equivalent was 352 g/eq. (theoretical value: 337 g/eq.) and the epoxy equivalent was 6020 g/eq.

### (theoretical value: 6394 g/eq.).

### (NMR Measurement Conditions)

Measurement instrument: AVANCE NEO 500 type nuclear magnetic resonance instrument (manufactured by Bruker BioSpin GmbH)
Measurement nuclei: 1H and 13C
Measurement mode: 1H = single pulse, 13C = single pulse proton broadband decoupling
Solvent: deuterated DMSO
Pulse angle: 1H=45°, 13C=30°
Sample concentration: 27% by weight (300 mg/0.75 mL)
Number of integrations: 1H=8 times, 13C=256 times

### (GPC Measurement Conditions)

Measurement instrument: "HLC-8420GPC" manufactured by Tosoh Corp.
Column: guard column "HXL-L" manufactured by Tosoh Corp. + "TSK-GEL SuperHZ2000" manufactured by Tosoh Corp. + "TSK-GEL SuperHZ2000" manufactured by Tosoh Corp. + "TSK-GEL SuperHZ3000" manufactured by Tosoh Corp. + "TSK-GEL SuperHZ4000" manufactured by Tosoh Corp.
Detector: RI (differential refractometer)
Data processor: "GPC Work Station EcoSEC-WorkStation" manufactured by Tosoh Corp.
Column temperature: 40°C
Developing solvent: tetrahydrofuran
Flow rate: 0.35 ml/min
Standard: monodisperse polystyrenes having known molecular weights described below were used in accordance with the measurement manual of the aforementioned "GPC WorkStation EcoSEC-WorkStation".
TSKgel F-10, F-4, F-1, A-5000, A-1000, and A-500 (manufactured by Tosoh Corp.)
Sample: tetrahydrofuran solution with the concentration of 0.2% by mass in terms of the resin solid, filtered through a microfilter (10 ul)

### (IR Measurement Conditions)

Measurement instrument: "FT/IR-4600" manufactured by JASCO Corp.

### (Measurement Method of Hydroxy Equivalent)

In accordance with JIS K0070, the hydroxy equivalent was measured by the back titration of acetic acid that remained after acetylation of the hydroxy group of the phenol resin with acetic anhydride-pyridine followed by hydrolysis.

### (Measurement Method of Epoxy Equivalent)

The epoxy equivalent was measured by the potentiometric titration in accordance with JIS K7236.

### <Example 2> Synthesis of polyhydric phenol resin (2)

612 g of a pale yellow resin was obtained in the same way as in Example 1 except that 430 g of a high molecular weight type epoxidized polybutadiene resin as the epoxidized polybutadiene resin ("JP-200", manufactured by Nippon Soda Co., Ltd., epoxy equivalent of 215 g/eq., in the aforementioned formula (x1), a=8 to 11 and a+c=35 to 43, R¹ and R² are a hydrogen atom)(2.0 mol of epoxy group) was used and that the amount of p-mercaptophenol was changed to 120 g (1.9 mol), as the raw material with the existence ratio of the structural units described above being (A) : [(B1) + (B2)] : (C) = 71:28:1 (molar ratio) as the raw material ratio, and with both R¹ and R² in the formulas being a hydrogen atom and n=0.

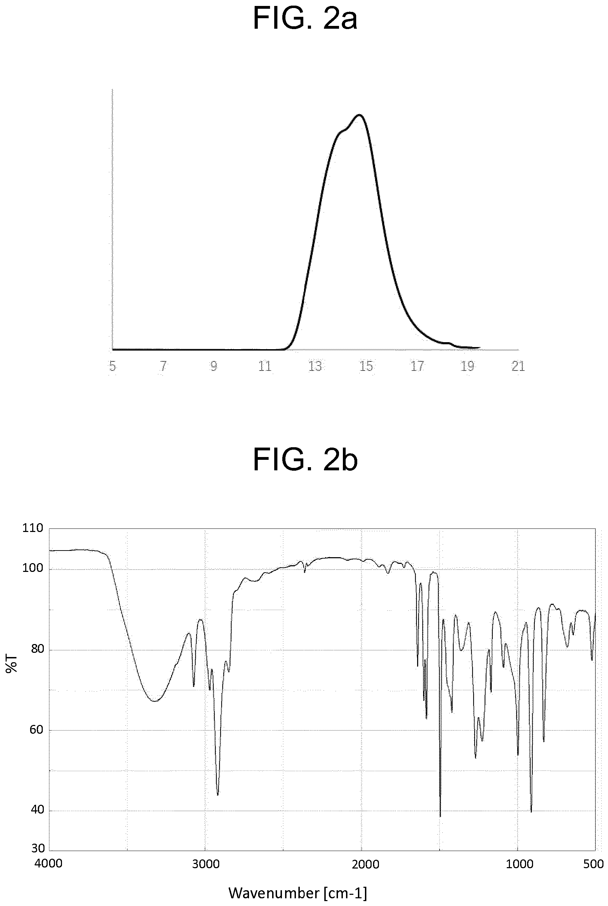

The resulting resin was measured by GPC and IR in the same way as in Example 1. The GPC and IR charts of the obtained resin are described in FIG. 2a and FIG. 2b, respectively. From these results, it was confirmed that the obtained resin had the intended molecular structure. The hydroxy equivalent and the epoxy equivalent of the resin measured in the same way as in Example 1 were 299 g/eq. (theoretical value: 289 g/eq.), and 5790 g/eq. (theoretical value: 6000 g/eq.), respectively.

### <Example 3> Synthesis of polyhydric phenol resin (3)

524 g of a pale yellow resin was obtained in the same way as in Example 1 except that the amount of p-mercaptophenol was changed to 126 g (1.0 mol) so as to change the existence ratio of the structural units to (A) : [(B1) + (B2)]: (C) = 70:15:15 (molar ratio) as the raw material ratio, with both R¹ and R² in the formulas being a hydrogen atom and n=0.

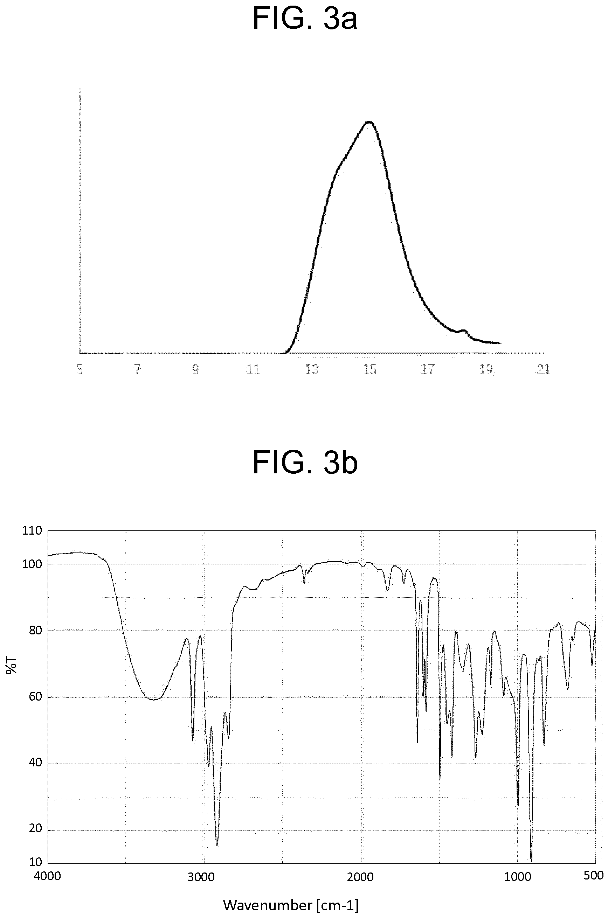

The resulting resin was measured by GPC and IR in the same way as in Example 1. The GPC and IR charts of the obtained resin are described in FIG. 3a and FIG. 3b, respectively. From these results, it was confirmed that the obtained resin had the intended molecular structure. The hydroxy equivalent and the epoxy equivalent of the resin measured in the same way as in Example 1 were 567 g/eq. (theoretical value: 556 g/eq.), and 539 g/eq. (theoretical value: 556 g/eq.), respectively. In other words, it was confirmed that approximately 50% by mole of the epoxy group in the raw material epoxidized polybutadiene resin was phenol-modified.

### <Examples 4 to 7 and Comparative Example 1>

### (1) Preparation of Resin Composition

Resin compositions having the compositions described in Table 1 below were prepared by using the synthesized polyhydric phenol resins (1) through (3). In preparation of these resin compositions, each raw material was mixed uniformly with heating at 100°C.

### (2) Production of Cured Product

The resin composition thereby prepared was charged into the casting frame having a gap of about 2 mm formed by placing a spacer between two glass plates coated with a mold releasing agent; then, this was heated at 150°C for 2 hours and then at 190°C for 3 hours to produce a sheet-like cured product.

Evaluation tests were conducted on the cured product according to the following procedures. The results are summarized in Table 2.

### [Flexural Toughness]

The flexural test was performed by using "AUTOGRAPH AG-X/R" manufactured by Shimadzu Corp. in accordance with JIS K7171. The energy per unit area calculated from the integral value of the S-S curve was used as the flexural toughness.

### [Tensile Toughness]

The tensile test was performed in accordance with JIS K7161 by using AUTOGRAPH AG-Xplus manufactured by Shimadzu Corp., and the energy per unit area calculated from the integral value of the S-S curve was used as the tensile toughness.

[Table 1]

**(Table 1)**

| | | | Examples | | | | Comparative Example |
|---|---|---|---|---|---|---|---|
| | | | 4 | 5 | 6 | 7 | 1 |
| Blending components (parts by mass) | Polyhydric phenol resin | Polyhydric phenol resin(1) | 35.2 | | | | |
| | | Polyhydric phenol resin(2) | | 29.9 | | | |
| | | Polyhydric phenol resin(3) | | | 56.7 | 56.7 | |
| | | DCPD type phenol resin | | | | | 10.5 |
| | Epoxy resin | | 18.3 | 18.3 | 1 8.3 | | 18.3 |
| | Curing accelerator | | 0.5 | 0.5 | 0.5 | 0.5 | 0.5 |

| | | | | | | | |
|---|---|---|---|---|---|---|---|
| * In terms of nonvolatile components Epoxy resin: liquid bisphenol A type epoxy resin ("EPICLON SSOS", epoxy equivalent of 183 g/eq., manufactured by DIC Corp.) DCPD type phenol resin: dicyclopentadiene-phenol polyaddition compound ("H-DPP85", manufactured by JFE Chemical Corp.) Curing accelerator: 2-ethyl-4-methylimidazole (manufactured by Shikoku Chemical Corp.) | | | | | | | |

[Table 2]

**(Table 2)**

| | Examples | | | | Comparative Example |
|---|---|---|---|---|---|
| | 4 | 5 | 6 | 7 | 1 |
| Flexural toughness (MPa) | 5.9 | 6.0 | 5.5 | 6.3 | 4.2 |
| Tensile roughness (MPa) | 2.0 | 2.2 | 1 .8 | 2.4 | 09 |

As can be seen in Table 2, the polyhydric phenol resins of the present invention were confirmed to achieve the cured product exhibiting favorable properties in both the flexural toughness and the tensile toughness. Furthermore, even when further including an inorganic filler (for example, 30 to 90% by mass when the amount of the nonvolatile components in the resin composition is defined as 100% by mass), or a cross-linkable resin such as other thermosetting resin or a radically polymerizable resin (for example, 10 to 60% by mass when the amount of the resin components in the resin composition is defined as 100% by mass), it was confirmed that the resin composition including the polyhydric phenol resin of the present invention was able to achieve the cured product thereof exhibiting the favorable toughnesses (flexural toughness is 10% or more and tensile toughness is 50% or more higher than the case that the polyhydric phenol resin of the present invention was not included).

## Claims

1. A polyhydric phenol resin (X) containing a polydiene skeleton, the polyhydric phenol resin (X) comprising
a structural unit represented by the following formula (1) : 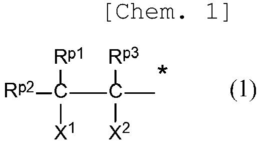 (in the formula (1),
R^{p1} and R^{p3} each independently represent a hydrogen atom, a methyl group, or an ethyl group,
R^{p2} represents a hydrogen atom, a methyl group, or a bond,
one of X¹ and X² represents a hydroxy group, and the other represents a monovalent group represented by the following formula (2), and
* represents a bond, where the C-C bond structure in the formula (1) is a part of the polydiene skeleton 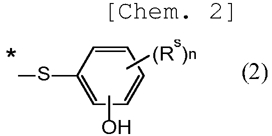 in the formula (2),
R^{S} each independently represents a substituent,
* represents a bond, and
n represents a number of 0 to 4).

2. The polyhydric phenol resin (X) according to claim 1, comprising
a structural unit A represented by the following formula (A), and
one or more of a structural unit B selected from a structural unit B1 represented by the following formula (B1) and a structural unit B2 represented by the following formula (B2): 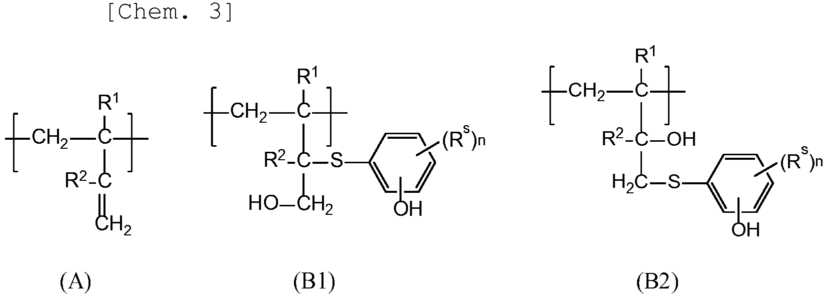 (in the formulas,
R¹ and R² each independently represent a hydrogen atom, a methyl group, or an ethyl group, and
R^{S} and n are the same as above).

3. The polyhydric phenol resin (X) according to claim 2, further comprising a structural unit C represented by the following formula (C): 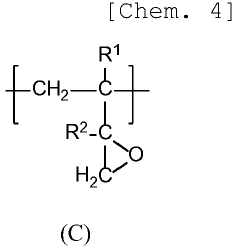 (in the formula, R¹ and R² each independently represent a hydrogen atom, a methyl group, or an ethyl group).

4. The polyhydric phenol resin (X) according to claim 2, wherein a molar ratio of the structural unit A to the structural unit B (structural unit A : structural unit B) is in a range of 15:85 to 85:15.

5. The polyhydric phenol resin (X) according to claim 3, wherein a molar ratio of the structural unit B to the structural unit C (structural unit B : structural unit C) is in a range of 20:80 to 100:0.

6. The polyhydric phenol resin (X) according to claim 1, wherein the polydiene skeleton is a polybutadiene skeleton.

7. The polyhydric phenol resin (X) according to claim 1, wherein a phenolic hydroxy equivalent is in a range of 200 to 1000 g/eq.

8. The polyhydric phenol resin (X) according to claim 3, wherein an epoxy equivalent is 3000 g/eq. or more.

9. The polyhydric phenol resin (X) according to claim 3, wherein a molar ratio of an epoxy group to a phenolic hydroxy group (epoxy group : phenolic hydroxy group) is in a range of 80:20 to 0:100.

10. The polyhydric phenol resin (X) according to claim 1, wherein the polyhydric phenol resin is a reaction product of an epoxy-modified polydiene compound (x1) with a mercaptophenol compound (x2).

11. The polyhydric phenol resin (X) according to claim 10, wherein the epoxy-modified polydiene compound (x1) comprises a structure represented by the following formula (x1) : 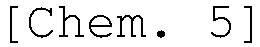 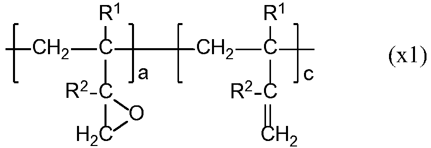 (in the formula,
R¹ and R² each independently represent a hydrogen atom, a methyl group, or an ethyl group, and
a and c represent an average number of each structural unit).

12. The polyhydric phenol resin (X) according to claim 10, wherein an epoxy equivalent of the epoxy-modified polydiene compound (x1) is in a range of 150 to 500 g/eq.

13. The polyhydric phenol resin (X) according to claim 10, wherein a reaction molar ratio of an epoxy group in the epoxy-modified polydiene compound (x1) to the mercaptophenol compound (x2) (epoxy group : mercaptophenol compound) is in a range of 100:10 to 100:100.

14. The polyhydric phenol resin (X) according to claim 10, wherein a content of an unreacted mercaptophenol compound (x2) is 10% by mass or less.

15. A method for producing the polyhydric phenol resin (X) according to any one of claims 1 to 14, the method comprising causing an epoxy-modified polydiene compound (x1) to react with a mercaptophenol compound (x2).

16. The method for producing the polyhydric phenol resin (X) according to claim 15, wherein a reaction temperature is in a range of 30 to 150°C.

17. The method for producing the polyhydric phenol resin (X) according to claim 15, wherein a reaction catalyst is not used substantially.

18. A resin composition comprising the polyhydric phenol resin (X) according to any one of claims 1 to 14.

19. The resin composition according to claim 18, wherein the resin composition is a thermosetting resin composition or a photo-curable resin composition.

20. The resin composition according to claim 18, further comprising a thermosetting resin.

21. The resin composition according to claim 18, further comprising an inorganic filler.

22. The resin composition according to claim 18, wherein the resin composition is for an insulating layer of a printed wiring board.

23. The resin composition according to claim 18, wherein the resin composition is for sealing semiconductor.

24. A resin sheet comprising a support and a layer of the resin composition according to claim 18 formed on the support.

25. The resin sheet according to claim 24, wherein the support is a thermoplastic resin film or metal foil.

26. A prepreg formed by impregnating a sheet-like fiber substrate with the resin composition according to claim 18.

27. A cured product of the resin composition according to claim 18.

28. A printed wiring board comprising an insulating layer formed of a cured product of the resin composition according to claim 18.

29. A semiconductor chip package comprising a sealing layer formed of a cured product of the resin composition according to claim 18.

30. The semiconductor chip package according to claim 29, wherein the semiconductor chip package is a fan-out type package.

31. A semiconductor device comprising the printed wiring board according to claim 28.

32. A semiconductor device comprising the semiconductor chip package according to claim 29.
